# EUROPEAN PATENT SPECIFICATION

(11) **EP 1 356 949 B1**
(45) Date of publication and mention of the grant of the patent: **19.07.2006**
(21) Application number: 03009322.3
(22) Date of filing: 24.04.2003
(51) Int. Cl.: B41N 3/08, G03F 7/32

(54) **Correction fluid for lithographic printing plate**
Korrekturflüssigkeit für lithographische Druckplatten
Liquide de correction pour une plaque d'impression lithographique

(30) Priority: 25.04.2002 JP 2002124166; 12.07.2002 JP 2002203488; 24.07.2002 JP 2002215279
(43) Date of publication of application: 29.10.2003
(73) Proprietor: FUJI PHOTO FILM CO., LTD., Minami-Ashigara-shi, Kanagawa-ken (JP)
(72) Inventor: Sakamoto, Atsushi, Yoshida-cho, Haibara-gun, Shizuoka-ken (JP); Toyama, Tadao, Yoshida-cho, Haibara-gun, Shizuoka-ken (JP); Sasaki, Hidehito, Yoshida-cho, Haibara-gun, Shizuoka-ken (JP); Nishioka, Akira, Yoshida-cho, Haibara-gun, Shizuoka-ken (JP)
(74) Representative: Grünecker, Kinkeldey, Stockmair & Schwanhäusser Anwaltssozietät

(56) References cited:
- EP-A- 0 517 960
- US-A- 3 248 332
- PATENT ABSTRACTS OF JAPAN vol. 1996, no. 01, 31 January 1996 (1996-01-31) -& JP 07 248631 A (KONICA CORP), 26 September 1995 (1995-09-26)
- PATENT ABSTRACTS OF JAPAN vol. 1997, no. 04, 30 April 1997 (1997-04-30) -& JP 08 324150 A (NIKKEN KAGAKU KENKYUSHO:KK), 10 December 1996 (1996-12-10)
- PATENT ABSTRACTS OF JAPAN vol. 011, no. 210 (M-604), 8 July 1987 (1987-07-08) -& JP 62 027190 A (KONISHIROKU PHOTO IND CO LTD), 5 February 1987 (1987-02-05)

## Description

### FIELD OF THE INVENTION

The present invention relates to a correction fluid for lithographic printing plate. More specifically, the present invention relates to a correction fluid for a lithographic printing plate prepared by photomechanical process or through the steps of exposure to laser and development so as to form an image portion and a non-image portion therein, the correction fluid being capable of deleting the image portion that is designed to repel a dampening water and accept an oil-based ink in the lithographic printing operation.

### BACKGROUND OF THE INVENTION

JP KOKOKU No. Sho 51-33442 (British Patent No. 1,408,709, JP KOKOKU means herein a Japanese patent publication for opposition purpose) discloses a correction fluid comprising a lactone having 3 to 6 carbon atoms which is used for a lithographic printing plate prepared from a pre-sensitized plate (hereinafter called "PS plate" in short) comprising a light-sensitive layer containing o-quinonediazide compound. JP KOKAI No. Sho 62-27190 (JP KOKAI herein means a publication of Japanese patent application) discloses a correction fluid for lithographic printing plate. The above-mentioned correction fluid is a composition using in combination a component A that comprises at least one compound selected from the group consisting of ethylene glycol diacetate, diethylene glycol dimethyl ether, diethylene glycol monomethyl ether, lactone, N,N-dimethylformamide, N-methylpyrrolidone, and cyclohexanone; a component B comprising at least one compound selected from the group consisting of phosphoric acid and acetic acid; and a component C comprising at least one compound selected from the group consisting of borofluoric acid and hydrosilicofluoric acid. Further, JP KOKAI No. Hei 8-324150 discloses a composition serving as a correction fluid, which employs a solvent containing an ether-linkage or amide-linkage therein in combination with a hexafluoro-metal (IV) acid, a fluorofatty acid, a difluorohydrogen alkaline compound, or ammonium fluoride. JP KOKAI No. Hei 7-248631 discloses a correction fluid which employs a combination of a carbonate compound such as ethylene carbonate or propylene carbonate, with a solvent capable of making an image portion soluble or swellable therein, such as N,N-dimethylformamide or N-methylpyrrolidone.

However, the above-mentioned conventional correction fluids have the shortcomings as shown below. The correction fluid disclosed in JP KOKOKU No. Sho 51-33442 has a drawback in workability. More specifically, the image portion formed in the lithographic printing plate has exhibited increased steadiness in line with the recent trend toward high printing durability, so that the solubility of the image portion in the employed correction fluid is lowered. The result is that the time needed for correction is considerably prolonged.

In the correction fluid disclosed in JP KOKAI No. Sho 62-27190, borofluoric acid or hydrosilicofluoric acid is used to remove the image portion component remaining in the grained substrate of the lithographic printing plate. However, the substrate of the printing plate is partially etched by the action of borofluoric acid or hydrosilicofluoric acid, so that the grained surface of the substrate which has been made hydrophilic is impaired. The portion thus damaged, which has to become a non-image portion tends to be easily stained with ink. Further, N,N-dimethylformamide and N-methylpyrrolidone are found to have a problem in safety, that is, to raise the possibility of jeopardizing the operators' health when the correction fluid comes in contact with the skin.

The correction fluid disclosed in JP KOKAI No. Hei 8-324150 has the problem that even though an image portion is recognized to have been apparently deleted from the printing plate in the course of the printing-plate-making process, ink is attached to the corresponding portion in the printing process. Another problem is that the solvent contained in the correction fluid gives off a smell that can adversely affect the operators' health.

In the correction fluid disclosed in JP KOKAI No. Hei 7-248631, a vapor of the solvent contained in the correction fluid affects any other image portions than an image portion that needs correction. Namely, there is the problem that the necessary image portions in proximity of the unnecessary image portion to be deleted are also easily removed from the printing plate. Further, there is a problem in safety of the solvents such as N,N-dimethylformamide and N-methylpyrrolidone, and the correction fluid can do serious harm to the operators' health when coming in contact with the skin.

According to JP KOKAI No. Hei 7-248631, it is proposed to employ an acid component for the correction fluid, selected from the group consisting of inorganic acids such as hydrofluoric acid, hydrochloric acid, sulfuric acid, persulfuric acid, nitric acid, permanganic acid, phosphoric acid, borofluoric acid, and hydrosilicofluoric acid; and organic acids such as acetic acid, citric acid, malic acid, lactic acid, oxalic acid, trichloroacetic acid, tannic acid, phytic acid, p-toluenesulfonic acid, and phosphonic acid. Due to the presence of such an acid component, however, a carbonic acid ester contained in the correction fluid is decomposed with the passage of time. Consequently, it is inevitable that not only the function of the correction fluid to delete the image portion will be impaired, but also the container holding the correction fluid therein will be deformed or damaged by generated gases to cause the problem of leakage of the correction fluid from the container. Further, when the acid materials as disclosed above are used for the correction fluid, the aluminum substrate portion located under the deleted image portion shows insufficient hydrophilic properties and becomes excessively damaged, so that the substrate portion tends to be smeared in the course of the printing process. JP-A-8324150 discloses an erases for a lithographic printing plate comprising a fluorine compound diluted with an organic solvent compatible with water.

### SUMMARY OF THE INVENTION

Accordingly, an object of the present invention is to provide a correction fluid for lithographic printing plate, which can delete only an image portion that needs correction without adversely affecting other image portions that are located adjacent to the target image portion and required to remain, with a special attention paid to the operators' health.

Another object of the present invention is to provide a correction fluid for lithographic printing plate, capable of deleting an image portion quickly, with the image-deleted portion not being stained.

A further object of the present invention is to provide a correction fluid for lithographic printing plate which can exhibit a function to delete an image portion with high stability over an extended period of time, without deformation or breakage of a container holding the correction fluid therein and leakage of the correction fluid from the container.

The present invention provides a correction fluid for lithographic printing plate, comprising a carbonic acid ester, and at least one compound selected from the group consisting of compounds selected from group (A) consisting of dimethylacetamide and diethylacetamide. Preferred embodiments are defined in claims 2 and 18.

The correction fluid of the present invention can be used for the lithographic printing plates prepared from any kinds of PS plates. In particular, the correction fluid of the present invention is suitably used for the lithographic printing plates obtained by subjecting thermal PS plates of positive-working mode or thermal polymerization type PS plates of negative-working mode, each comprising an image recording layer which contains an infrared absorption agent, to the steps of image-wise exposure and development. Also, the correction fluid according to the present invention can be suitably used for correcting the image portions in the lithographic printing plates obtained by subjecting PS plates of photopolymerizable type to the steps of image-wise exposure and development.

The correction fluid of the present invention can delete an image portion very quickly without any effect on other image portions that do not need correction. A peculiar action obtained by the combination of the carbonic acid ester and the compound represented by group (A) can prevent acid compounds from damaging a substrate, so that the image-deleted portion does not produce the problem of stains. The correction fluid of the present invention contains no compound that has the problem of safety, so that the correction fluid is harmless to the operators' health. The correction fluid of the present invention can exhibit a deleting function with high stability over an extended period of time, and there is no cause for concern about the deformation or breakage of the container for the correction fluid, and therefore about the leakage of the fluid from the container.

### DETAILED DESCRIPTION OF THE INVENTION

The components for use in the correction fluid of the present invention will now be explained in detail.

### [1] Carbonic Acid Esters

As the carbonic acid ester for use in the correction fluid of the present invention, the following compounds represented by formula (2) or (3) are preferably employed:

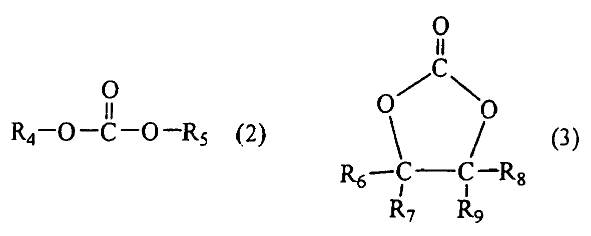

In the above formula (2), R₄ and R₅, which may be the same or different, are each an alkyl group, a cycloalkyl group, an alkenyl group or an aryl group. The above-mentioned alkyl group, cycloalkyl group, alkenyl group and aryl group may have a substituent. In the formula (3), R₆ to R₉, which may be the same or different, are each hydrogen atom, an alkyl group, a cycloalkyl group, an alkenyl group or an aryl group. The above-mentioned alkyl group, cycloalkyl group, alkenyl group and aryl group may have a substituent. R₆ and R₇, R₈ and R₉, or R₇ and R₉ may form a ring in combination.

The alkyl group represented by R₄, R₅, R₆, R₇, R₈ and R₉ may have, for example, 1 to 8 carbon atoms. For example, methyl group, ethyl group, propyl group, n-butyl group, sec-butyl group, hexyl group, 2-ethylhexyl group and octyl group, each of which may have a substituent, can be preferably used. The cycloalkyl group may be a monocyclic group or a polycyclic group, and, in particular, monocyclic groups having 3 to 8 carbon atoms, for example, cyclopropyl group, cyclopentyl group, and cyclohexyl group, each of which may have a substituent, are preferably employed. With respect to the alkenyl group, alkenyl groups having 2 to 8 carbon atoms, for example, vinyl group, allyl group, butenyl group and cyclohexenyl group, each of which may have a substituent are preferably used. As the aryl group, aryl groups having 6 to 15 carbon atoms, for example, phenyl group, tolyl group, dimethylphenyl group, 2,4,6-trimethylphenyl group, naphthyl group, and anthryl group, each of which may have a substituent, are preferably used.

The ring formed by two groups, that is, R₆ and R₇, R₈ and R₉, or R₇ and R₉ includes, for example, five- to eight-membered rings. Specific examples of such rings are cyclopentane ring, cyclohexane ring, cycloheptane ring, and cyclooctane ring. Each of the above-mentioned rings may have a substituent.

Examples of the substituent for the above-mentioned groups include an active hydrogen containing group such as amide group, ureido group and hydroxyl group; a halogen atom such as fluorine atom, chlorine atom, bromine atom and iodine atom; an alkoxyl group such as methoxy group, ethoxy group, propoxy group and butoxy group; a thioether group; an acyl group such as acetyl group, propanoyl group and benzoyl group; a cyano group; and a nitro group.

Specific examples of the carbonic acid esters represented by formula (2) or (3) are dimethyl carbonate, ethyl methyl carbonate, diethyl carbonate, diphenyl carbonate, ethylene carbonate and propylene carbonate. Those carbonic acid esters may be used alone or in combination. Of the above-mentioned carbonic acid esters, ethylene carbonate and propylene carbonate are particularly preferable. In particular, it is preferable to use ethylene carbonate and propylene carbonate in combination for the purpose of improving the solubility of an image portion in the correction fluid and the water-washing properties of the portion from which an image has been deleted, and keeping the correction fluid in a liquid state at room temperature. Such a combination can drastically enhance the capabilities of the correction fluid. In this case, the mixing ratio by weight of ethylene carbonate to propylene carbonate is not particularly limited, but preferably in the range of (90:10) to (10:90), and more preferably in the range of (90:10) to (50:50).

In the correction fluid of the present invention, it is proper that the content of the carbonic acid ester be in the range of 20 to 80% by weight, preferably 30 to 70% by weight, based on the total weight of the correction fluid.

### [2] Compounds of Group (A)

Specific examples of the compound of group (A) are dimethylacetamide, and diethylacetamide.

Those compounds represented of group (A) may be used alone or in combination in the correction fluid of the present invention. In light of the solubility of an image portion in the correction fluid and the water-washing properties of the portion from which an image has been deleted, dimethylacetamide, and diethylacetamide are preferable. Of those, in particular, dimethylacetamide is most preferable.

In the correction fluid of the present invention, it is proper that the content of the compound of group (A) be in the range of 5 to 50% by weight, preferably 10 to 40% by weight, based on the total weight of the correction fluid.

The ratio by weight of the above-mentioned carbonic acid ester to the compound of group (A) is not particularly limited, but preferably in the range of (90:10) to (10:90), more preferably in the range of (80:20) to (20:80).

It is preferable that the total amount of the carbonic acid ester and the compound of group (A) be in the range of 40 to 90% by weight, more preferably 60 to 90% by weight, based on the entire weight of the correction fluid.

### [3] Compounds of Group (B)

### (3-1) Fluorocarboxylic acids

Examples of the fluorocarboxylic acids for use in the present invention include fluorofatty acids and fluorodicarboxylic acids. More specifically, the fluorocarboxylic acids can be represented by formula of CₙF₂ₙ₊₁COOH or HOOCCₙF₂ₙCOOH, wherein n is an integer of 1 to 6. Representative examples are trifluoroacetic acid, tetrafluorosuccinic acid and the like.

### (3-2) Hydrogen fluoride alkaline compounds

Examples of the hydrogen fluoride alkaline compounds for use in the present invention are represented by formula of MF·HF, wherein M is an alkali metal or N(R²¹) (R²²)(R²³) (R²⁴), in which R²¹, R²², R²³ and R²⁴ may be the same or different, and each represent hydrogen atom or a hydrocarbon group, for example, having 1 to 6 carbon atoms. Representative examples of the hydrogen fluoride alkaline compounds include lithium bifluoride, potassium bifluoride, sodium bifluoride, and ammonium bifluoride.

### (3-3) Fluoroalkaline compounds

Examples of the fluoroalkaline compounds for use in the present invention are represented by formula of M'F, wherein M' is an alkali metal or N(R³¹) (R³²)(R³³) (R³⁴), in which R³¹, R³², R³³ and R³⁴ may be the same or different, and each represent hydrogen atom or a hydrocarbon group, for example, having 1 to 6 carbon atoms. Representative examples of the fluoroalkaline compounds are lithium fluoride, potassium fluoride, sodium fluoride, and ammonium fluoride.

### (3-4) Hydrofluoric acids of a metal belonging to Group 4 of Periodic Table

Examples of hydrofluoric acids of a metal belonging to Group 4 of Periodic Table include compounds represented by M"H₂F₆, wherein M" is a metal element belonging to Group 4 of Periodic Table. For example, fluorozirconic acid and fluorotitanic acid can be used in the present invention.

One compound may be selected from the group (B) consisting of the above-mentioned compounds (3-1) to (3-4), or two or more compounds may be used in combination. In particular, fluorozirconic acid and fluorotitanic acid are preferable from the viewpoint of prevention of stains at the image-deleted portion. The use of fluorozirconic acid is most preferable. The content of the fluorine-containing compound belonging to the group (B) is preferably in the range of 0.01 to 20.0% by weight, more preferably in the range of 0.1 to 10.0% by weight, based on the total weight of the correction fluid.

The correction fluid of the present invention comprises at least one compound selected from the group (A) and preferably in addition thereto at least one compound selected from the group (B).

### [4] Acid Compounds

The correction fluid of the present invention may further comprise an acid compound. In particular, a phosphorus-containing acid and a fluorine-containing acid are suitably used as the acid compounds.

Specific examples of the phosphorus-containing acid include phosphoric acid compounds such as phosphoric acid, phosphorous acid, phytic acid, and metaphosphoric acid; and phosphonic acid compounds such as 1-hydroxyethylidene-1,1-diphosphonic acid, 1,2-diphosphono-1,2-dicarboxyethane, 1,2,2,3-tetraphosphonopropane, 2(2'-phosphonoethyl) pyridine, aminotri(methylenephosphonic acid), vinylphosphonic acid, polyvinylphosphonic acid, 2-phosphonoethane-1-sulfonic acid, and water-soluble copolymers of vinylphosphonic acid and acrylic acid and/or vinyl acetate. Those phosphorus-containing acids may be used alone or in combination. In particular, phosphoric acid is preferably used to effectively prevent the portion from which an image has been deleted from being stained. It is proper that the amount of the phosphorus-containing acid be within the range of 0.1 to 20.0% by weight, preferably 0.1 to 10.0% by weight, based on the total weight of the correction fluid.

Specific examples of the fluorine-containing acid include hydrosilicofluoric acid, borofluoric acid and the like. Such fluorine-containing acids may be used alone or in combination. The above-mentioned hydrosilicofluoric acid and borofluoric acid are particularly preferable in light of the prevention of stains. It is proper that the amount of the fluorine-containing acid be within the range of 0.01 to 20.0% by weight, preferably 0.1 to 10.0% by weight, based on the total weight of the correction fluid.

The correction fluid of the present invention may comprise either the phosphorus-containing acid or the fluorine-containing acid, or both.

In addition to the above-mentioned phosphorus-containing acid or fluorine-containing acid, mineral acids such as sulfuric acid, nitric acid and hydrochloric acid, malic acid, citric acid, tartaric acid, gluconic acid, tannic acid, oxalic acid, acetic acid, lactic acid, p-toluenesulfonic acid and the like can be used as the acid compounds.

### [5] Base Compounds

The correction fluid of the present invention may further comprise a base compound. Specific examples of the base compound include inorganic alkaline chemicals such as sodium hydroxide, potassium hydroxide, lithium hydroxide, trisodium phosphate, tripotassium phosphate, triammonium phosphate, disodium hydrogenphosphate, dipotassium hydrogenphosphate, diammonium hydrogenphosphate, sodium carbonate, potassium carbonate, ammonium carbonate, sodium bicarbonate, potassium bicarbonate, ammonium bicarbonate, sodium borate, potassium borate, ammonium borate, sodium silicate, potassium silicate, lithium silicate, and ammonium silicate; potassium citrate, tripotassium citrate, and sodium citrate.

Organic alkaline chemicals such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, and tetramethylammonium hydroxide are also preferably used as the base compounds.

Those base compounds may be used alone or in combination.

Of the above-mentioned base compounds, organic alkaline chemicals are preferably used, in particular, triethanolamine is most preferable. It is proper that the amount of the base compound be in the range of 0.01 to 20.0% by weight, preferably in the range of 0.1 to 10.0% by weight, based on the total weight of the correction fluid.

It is proper that the correction fluid according to the present invention have a pH value in the range from 1 to 9. The pH range is preferably from 4 to 9, and more preferably from 4 to 7 in order to enhance the preservation stability of the correction fluid. In the pH range of 4 to 9, decomposition of the carbonic acid ester can be effectively inhibited, so that the deformation and breakage of the container and the leakage of the fluid from the container can be prevented.

The correction fluid may be adjusted to be within the aforementioned desired pH range by adding either the acid compound or the base compound to the correction fluid of the present invention. Alternatively, a desired pH range may be obtained through a neutralizing reaction by employing the acid compound and the base compound at the same time. The latter method is more preferable in light of the prevention of stains.

### [6] Water

Preferably, the correction fluid of the present invention may further comprise water. When the correction fluid comprising the carbonic acid ester in combination with water is applied to an image portion that needs correction, the presence of water can serve to prevent the surrounding image portions from becoming blurred. Further, water is effective as a solubilizer for the acid compound and the base compound. It is proper that the amount of water be in the range of 3 to 20% by weight, preferably 5 to 15% by weight, based on the total weight of the correction fluid. The above-mentioned carbonic acid ester, acid compound and base compound are usually dissolved in water in the preparation of the correction fluid.

### [7] Other Components

### (7-1) Solvents

If necessary, the correction fluid of the present invention may further comprise an organic solvent with a boiling point of 120°C or more capable of causing an image or ink to be soluble or swellable therein. Such an organic solvent includes alcohols, ketones, glycol ethers, lactones having 3 to 12 carbon atoms, and esters or hydrocarbons.

Specific examples of the above-mentioned alcohols are n-hexanol, 2-ethylbutanol, n-heptanol, n-octanol, 2-ethylhexanol, nonanol, cyclohexanol, 2-methylcyclohexanol, benzyl alcohol, and tetrahydrofurfuryl alcohol.

Specific examples of the ketones are methyl ethyl ketone, methyl isobutyl ketone, methylamyl ketone, methyl-n-hexyl ketone, di-n-propyl ketone, diacetone alcohol, acetonylacetone, isophorone, phorone, cyclohexanone, methylcyclohexanone, and acetophenone.

With respect to the glycol ethers, compounds represented by the following formula (I) or (II) can be used:

R⁵¹O - (CH₂CH(R⁵²) - O)ₘ - R⁵³ (I)

R⁵⁴O - (CH₂CH₂ - O)ₚ - CO - CH₃ (II)

wherein R⁵¹ to R⁵⁴ are each independently hydrogen atom, an alkyl group having 1 to 8 carbon atoms, benzyl group, phenyl group or cycloalkyl group; and m and p are each an integer ranging from 1 to 20.

Specific examples of the compounds represented by the above formula (I) or (II) are ethylene glycol monomethyl ether, diethylene glycol monomethyl ether, triethylene glycol monomethyl ether, diethylene glycol dimethyl ether, ethylene glycol monomethyl ether acetate, ethylene glycol monoethyl ether, diethylene glycol monoethyl ether, triethylene glycol monoethyl ether, diethylene glycol diethyl ether, ethylene glycol monoethyl ether acetate, ethylene glycol monobutyl ether, diethylene glycol monobutyl ether, triethylene glycol monobutyl ether, diethylene glycol dibutyl ether, ethylene glycol monobutyl ether acetate, ethylene glycol monobenzyl ether, diethylene glycol monobenzyl ether, propylene glycol monomethyl ether, dipropylene glycol monomethyl ether, tripropylene glycol monomethyl ether, dipropylene glycol dimethyl ether, propylene glycol monoethyl ether, dipropylene glycol monoethyl ether, tripropylene glycol monoethyl ether, and dipropylene glycol diethyl ether.

Specific examples of the lactones having 3 to 12 carbon atoms are γ-butyrolactone, γ-valerolactone, γ-caprolactone, γ-caprylolactone, γ-laurolactone, δ-valerolactone, δ-caprolactone, ε-caprolactone, crotonolactone, α-angelica lactone, β-angelica lactone, and hexanolactone.

Specific examples of the esters and hydrocarbons are amyl acetate, isoamyl acetate, methylisoamyl acetate, 2-hexyl acetate, 2-ethylbutyl acetate, 2-ethylhexyl acetate, cyclohexyl acetate, methylcyclohexyl acetate, benzyl acetate, butyl propionate, isoamyl propionate, butyl butyrate, isobutyl butyrate, isoamyl butyrate, butyl lactate, amyl lactate, isoamyl lactate, toluene, xylene, mesitylene, tetramethylbenzene, ethylbenzene, methylethylbenzene, methylpropylbenzene, diethylbenzene, petroleum fractions with a boiling point of about 120 to 300°C, and methylnaphthalene. Of those esters and hydrocarbons, mesitylene, tetramethylbenzene, methylethylbenzene, methylpropylbenzene, methylisoamyl acetate, cyclohexyl acetate, benzyl acetate, and amyl lactate are particularly preferable.

In addition to the above, cyclohexanone, sulfolane, dioxolane, dimethylsulfoxide, polyethylene glycol and polypropylene glycol having a molecular weight of 200 to 1000; and monomethyl ethers, monoethyl ethers, monopropyl ethers, isopropyl ethers and monobutyl ethers of the above-mentioned compounds can be used as the solvents.

Those organic solvents may be used alone or in combination. When the correction fluid comprises such an organic solvent, it is proper that the amount of the organic solvent be in the range of 1 to 20% by weight, preferably 5 to 15% by weight, based on the total weight of the correction fluid.

### (7-2) Water-soluble high molecular weight compounds

The correction fluid of the present invention may further comprise a water-soluble high molecular weight compound to impart still more outstanding performance to the correction fluid. By adding the water-soluble polymer compound to the correction fluid, the correction fluid can spread smoothly and evenly within a target image portion, with the adjacent image portions being prevented from becoming blurred when the correction fluid is applied to the target image portion in the lithographic printing plate with a brush. The water-soluble high molecular weight compound is sufficiently compatible with the carbonic acid ester solvent, and is suitably used to provide the correction fluid with a proper viscosity.

Preferable examples of the above-mentioned water-soluble high molecular weight compounds include modified cellulose such as methyl cellulose, hydroxypropyl cellulose, hydroxypropylmethyl cellulose, and sodium salt of carboxymethyl cellulose, and high-molecular compounds such as gum arabic, stractan, polyvinyl pyrrolidone, polyvinyl methyl ether, polyethylene glycol, polypropylene glycol, vinyl methyl ether - maleic anhydride copolymer, and vinyl acetate - maleic anhydride copolymer. Of those high molecular weight compounds, modified cellulose, polyvinyl pyrrolidone, vinyl methyl ether - maleic anhydride copolymer, and stractan are particularly useful. Such water-soluble high molecular weight compounds may be used alone or in combination. The amount of the water-soluble high molecular weight compound is preferably in the range of 0.1 to 10% by weight, more preferably 0.3 to 5% by weight, based on the total weight of the correction fluid.

### (7-3) Surfactants

The correction fluid of the present invention may further comprise a surfactant to allow each component contained in the correction fluid to more smoothly penetrate into the image portion formed in the lithographic printing plate. Furthermore, the surfactant is effective for keeping a correction fluid in a stable solution state where all the components are uniformly blended.

Examples of the surfactants include nonionic surfactants such as polyoxyethylene alkyl ether, polyoxyethylene alkylphenyl ether, polyoxyethylene polystyrylphenyl ether, polyoxyethylene polyoxypropylene alkyl ether, partial ester of glycerin fatty acid, partial ester of sorbitan fatty acid, partial ester of pentaerythritol fatty acid, propylene glycol monofatty acid ester, partial ester of sucrose fatty acid, oxyethylene - oxypropylene block copolymer, trimethylolpropane, adduct of glycerin or the like with oxyethylene and oxypropylene, partial ester of polyoxyethylene sorbitan fatty acid, partial ester of polyoxyethylene sorbitol fatty acid, polyethylene glycol fatty acid ester, partial ester of polyglycerin fatty acid, castor oil modified with polyoxyethylene, partial ester of polyoxyethylene glycerin fatty acid, fatty acid diethanolamide, N,N-bis-2-hydroxyalkylamine, polyoxyethylene alkylamine, triethanolamine fatty acid ester, and trialkylamine oxide; anionic surfactants such as fatty acid salt, abietate, hydroxyalkanesulfonate, alkanesulfonate, dialkylsulfosuccinate, linear alkylbenzenesulfonate, branched alkylbenzenesulfonate, alkylnaphthalenesulfonate, alkylphenoxy polyoxyethylenepropylsulfonate, polyoxyethylene alkylsulfophenyl ether salt, sodium salt of N-methyl-N-oleyltaurine, disodium salt of N-alkylsulfosuccinic monoamide, petroleum sulfonate, sulfated castor oil, sulfated tallow oil, sulfate of fatty acid alkyl ester, alkyl sulfate, polyoxyethylene alkyl ether sulfate, fatty acid monoglyceride sulfate, polyoxyethylene alkylphenyl ether sulfate, polyoxyethylene styrylphenyl ether sulfate, alkyl phosphate, polyoxyethylene alkyl ether phosphate, polyoxyethylene alkylphenyl ether phosphate, partially saponified styrene - maleic anhydride copolymer, partially saponified olefin - maleic anhydride copolymer, and condensate of naphthalenesulfonate and formalin; cationic surfactants such as alkylamine salt, quaternary ammonium salt, polyoxyethylene alkylamine salt, and polyethylene polyamine derivative; ampholytic surfactants such as carboxybetaine, aminocarboxylic acid, sulfobetaine, aminosulfate, and imidazoline; and fluorine-containing or silicon-containing surfactants. The term "polyoxyethylene" mentioned in the above surfactants can be replaced by other polyoxyalkylene such as "polyoxymethylene", "polyoxypropylene" or "polyoxybutylene".

Of the above-mentioned surfactants, the nonionic surfactants and anionic surfactants are preferable, in particular, the surfactants with a HLB of 9 or more are more preferable because all the components contained in the correction fluid can be sufficiently mixed. Especially, the nonionic surfactants are preferably employed because the wettability of the image portion by the correction fluid and the penetrability of the correction fluid into the image portion are improved to accelerate the correction rate. For example, polyoxyethylene alkylphenyl ether, polyoxyethylene alkyl ether, oxyethylene - oxypropylene block copolymer, partial ester of polyoxyethylene sorbitan fatty acid, partial ester of polyoxyethylene sorbitol fatty acid, polyethylene glycol fatty acid ester, and partial ester of polyglycerin fatty acid are particularly preferable in light of the effect of deleting the image portion.

A preferable example of the nonionic surfactants for use in the present invention is represented by the following formula (4):

R⁶⁰O - (CH₂CH₂O)ₘ(CH(CH₃)CH₂O)ₙ (CH₂CH₂O)ₚ - R⁶¹ (4)

wherein R⁶⁰ and R⁶¹ are each independently hydrogen atom, or a straight-chain or branched alkyl group or alkenyl group having 1 to 18 carbon atoms, m+p is an integer ranging from 1 to 300, and n is an integer ranging from 0 to 100.

More specifically, the surfactants represented by formula (4) include a compound where at least one of R⁶⁰ or R⁶¹ represents hydrogen atom; or a compound where one of R⁶⁰ or R⁶¹ is hydrogen atom, and the other represents hydrogen atom, -CH₃, -C₂H₅, -C₃H₇, -C₄H₉, or -CH₂CH=CH₂. Preferably, m+p is an integer ranging from 1 to 240, and n is an integer of from 2 to 100, more preferably 2 to 70.

The most preferable nonionic surfactant represented by the above-mentioned formula (4) is oxyethylene - oxypropylene block copolymer where both R⁶⁰ and R⁶¹ represent hydrogen atom.

Preferably, the nonionic surfactants for use in the present invention have a propylene glycol moiety with a weight average molecular weight of 1200 to 3500, and an ethylene oxide moiety in an amount of about 40 to 90% by weight.

Those surfactants may be used alone or in combination. It is proper that the content of the surfactant be in the range of 0.01 to 40% by weight, preferably 0.1 to 25% by weight, based on the total weight of the correction fluid of the present invention.

### (7-4) Viscosity modifier

The correction fluid of the present invention may further comprise a viscosity modifier. The addition of the viscosity modifier can impart still more improved writing characteristics to the correction fluid. When an image portion in the lithographic printing plate is corrected using a brush filled with the correction fluid of the present invention, dripping of the correction fluid from the brush can be prevented effectively if the viscosity modifier is added to the correction fluid. Although some of the previously mentioned water-soluble high molecular weight compounds can also serve as the viscosity modifier, finely-divided particles of silicic acid, colloidal silica, zeolite and the like are preferably added to the correction fluid as the viscosity modifier because such finely-divided particles can exhibit excellent performance as the viscosity modifier. The mean particle size of such finely-divided particles is preferably within the range of 1 to 200 nm, more preferably 5 to 100 nm. When the mean particle size of the finely-divided particles is within the above-mentioned range, the finely-divided particles have an affinity for the carbonic acid ester solvent, thereby providing the correction fluid with appropriate thixotropy.

Specific examples of the preferable finely-divided particles are shown below:
commercially available products of Nippon Aerosil Co., Ltd., such as silicon dioxide powders "AEROSIL 130" (about 16 nm), "AEROSIL 200" (about 12 nm), "AEROSIL 300" (about 7 nm), "AEROSIL 380" (about 7 nm), "AEROSIL R-972" (about 16 nm), "AEROSIL MOX170" (about 15 nm), "AEROSIL OX50" (about 40 nm), "AEROSIL TT600" (about 40 nm), "AEROSIL MOX80" (about 30 nm), "SILICA K320DS" (about 18 nm), "SILTEG AS7" (about 35 nm), "CALSIL" (about 40 nm), and "SILICA D 17" (about 20 nm), aluminum oxide powder "Aluminum Oxide C" (about 20 nm), and titanium oxide powder "Titanium Oxide P25" (about 30 nm), all of which are trademarks of Nippon Aerosil Co., Ltd., with the numerals in parentheses indicating the mean particle diameter of the primary particle; and
commercially available products of Nissan Chemical Industries, Ltd., such as colloidal alumina "ALUMINASOL 520" (particle average diameter of about 10 to 20 nm), "ALUMINASOL 100" (particle size average: 100 nm x 10 nm), and "ALUMINASOL 200" (particle size average: 100 nm x 10 nm), and colloidal silica "SNOWTEX 20" (particle diameter of 10 to 20 nm), "SNOWTEX 30" (particle diameter of 10 to 20 nm), "SNOWTEX C" (particle diameter of 10 to 20 nm), "SNOWTEX N" (particle diameter of 10 to 20 nm), and "SNOWTEX O" (particle diameter of 10 to 20 nm), all of which are trademarks of Nissan Chemical Industries, Ltd.

Among those finely-divided particles, silicon dioxide particles are especially preferable, in particular, with a particle diameter of 5 to 100 nm.

When the particle diameter of the finely-divided particles is less than 1 nm, the particles tend to aggregate, with the result that the viscosity of the correction fluid will fluctuate. The particle diameter of more than 200 nm cannot provide the correction fluid with proper thixotropy.

It is proper that the amount of the viscosity modifier be in the range of 1 to 10% by weight, preferably 3 to 8% by weight, based on the total weight of the correction fluid.

### (7-5) Others (coloring agent, antiseptic, rust preventive and anti-foaming agent)

In addition to the above, a coloring agent, an antiseptic, a rust preventive, and an anti-foaming agent may be contained in the correction fluid of the present invention.

The coloring agent is used to impart a desired color tone to the correction fluid of the present invention, thereby providing a visual contrast. The coloring agent can be selected from a wide variety of dyes. In particular, intensely colored dyes such as blue, purple or red-colored indicating dyes can exhibit a significant effect, so that those colored dyes can be preferably used. Specific examples of such dyes include inorganic dyes and organic dyes, such as Crystal Violet, Safranine, Brilliant Blue, Malachite Green, and Acid Rhodamine B. When such a dye is used as the coloring agent, the amount of the dye is preferably in the range of about 0.0001 to about 0.10% by weight, more preferably 0.001 to 0.05% by weight, based on the total weight of the correction fluid of the present invention.

Examples of the antiseptic for use in the present invention include phenol and derivatives thereof, formalin, imidazole derivatives, sodium dehydroacetate, 4-isothiazolin-3-on derivatives, benzoisothiazolin-3-on, benztriazole derivatives, amidine guanidine derivatives, quaternary ammonium salts, pyridine derivatives, quinoline derivatives, guanidine derivatives, diazine, triazole derivatives, oxazole, oxazine derivatives, and 2-bromo-2-nitropropane-1,3-diol. The antiseptic may be added in such an amount that can exhibit a practical effect on bacteria, mold, yeast and the like with stability. The amount of the antiseptic, which varies depending upon the kind of bacteria, mold, yeast and the like, may be preferably in the range of 0.01 to 4% by weight based on the total weight of the correction fluid. To protect the correction fluid from various kinds of mold and bacteria, it is preferable to employ two or more kinds of antiseptics.

As the anti-foaming agent, a silicone anti-foaming agent is preferably used. The silicone anti-foaming agent includes an emulsification dispersion type anti-foaming agent and a solubilization type anti-foaming agent, both of which can be used in the present invention. It is suitable that the anti-foaming agent be contained in an amount of 0.001 to 1.0% by weight based on the total weight of the correction fluid.

Examples of the rust preventive include 1H-benzotriazole and derivatives thereof, benzimidazole and derivatives thereof, and thiosalicylic acid. The amount of the rust preventive is preferably in the range of 0.0001 to 0.1% by weight based on the total weight of the correction fluid.

The correction fluid of the present invention can be used for the lithographic printing plates prepared from a variety of PS plates for lithographic printing. The PS plates for use in making the lithographic printing plates are not particularly limited. For example, the correction fluid of the present invention is effective for the lithographic printing plate prepared from the PS plates which comprise a substrate and an image recording layer formed thereon, the image recording layer being a photosensitive layer or a heatsensitive layer as shown below. Namely, the correction fluid of the present invention is applicable to various kinds of image recording layers of a conventional PS plate of positive-working mode, a conventional PS plate of negative-working mode, a PS plate of photopolymerizable type, a thermal PS plate of positive-working mode, and a thermal PS plate of negative-working mode (including a thermal polymerization type and an acid cross-linking type). The conventional PS plates herein used mean PS plates for conventional lithographic printing process where light exposure is imagewise conducted through a transparent positive and a transparent negative. The above-mentioned PS plates will be now explained in detail in terms of the respective image recording layers and developing solutions suitable therefor.

### [Conventional PS plate of positive-working mode]

A composition comprising o-quinonediazide compound and an alkali-soluble polymer compound is one of the preferable photosensitive resin compositions for use in the conventional PS plate of positive-working mode. Examples of the o-quinonediazide compound include esters of 1,2-naphthoquinone-2-diazide-5-sulfonyl chloride and phenol-formaldehyde resin or cresol-formaldehyde resin, and esters of 1,2-naphthoquinone-2-diazide-5-sulfonyl chloride and pyrogallol-acetone resin (disclosed in U.S. Patent No. 3,635,709). As the alkali-soluble polymer compound, for example, there are phenol-formaldehyde resin, cresol-formaldehyde resin, phenol-cresol-formaldehyde co-condensation resin, polyhydroxystyrene, N-(4-hydroxyphenyl)methacrylamide copolymer, and a carboxyl group-containing polymer disclosed in JP KOKAI No. Hei 7-36184. Furthermore, other alkali-soluble polymer compounds, for example, a phenolic hydroxyl group-containing acrylic resin as described in JP KOKAI No. Sho 51-34711, a sulfonamide group-containing acrylic resin as described in JP KOKAI No. Hei 2-866, and various urethane resins can also be employed. In addition, the photosensitive resin composition may preferably comprise a sensitivity controlling agent, a printing-out agent, and a dye as disclosed in JP KOKAI No. Hei 7-92660 (paragraphs from [0024] to [0027]), and a surfactant for enhancing the coating properties as shown in the paragraph [0031] of JP KOKAI No. Hei 7-92660.

The conventional photosensitive PS plate of positive-working mode comprising a substrate and an image recording layer which comprises the photosensitive resin composition of an o-quinonediazide compound and an alkali-soluble polymer compound is imagewise exposed to ultraviolet rays. After that, images are developed using an alkaline developing solution. In this case, a water-soluble solution of alkali metal silicate as described in JP KOKOKU No. Sho 57-7427 and JP Patent No. 3,086,354, and a developing solution comprising a nonreducing saccharide and a base as the main components as described in JP KOKAI No. Hei 8-305039 can be preferably used as the developing solutions.

### [Conventional PS plate of negative-working mode]

There can be employed a photosensitive resin composition of a diazo resin and an alkali-soluble or alkali-swellable polymer compound serving as a binder agent for the conventional PS plate of negative-working mode.

Examples of the diazo resin are a condensation product of an aromatic diazonium salt and an active carbonyl group-containing compound such as formaldehyde, and an organic solvent-soluble diazo resin inorganic salt, that is, a reaction product of a condensation product of p-diazophenylamine and formaldehyde with hexafluorophosphate or tetrafluoroborate. In particular, a high-molecular weight diazo compound containing a hexamer or more in an amount of 20 mol% or more, as disclosed in JP KOKAI No. Sho 59-78340, is preferably used. Preferable examples of the binder agent are copolymers including as an indispensable component acrylic acid, methacrylic acid, crotonic acid, or maleic acid, for example, copolymers comprising a monomer such as 2-hydroxyethyl (meth)acrylate, (meth)acrylonitrile, and (meth)acrylic acid as disclosed in JP KOKAI No. Sho 50-118802; and copolymers comprising alkylacrylate, (meth)acrylonitrile, and unsaturated carboxylic acid as disclosed in JP KOKAI No. Sho 56-4144. It is preferable that the photosensitive resin composition further comprise, as shown in JP KOKAI No. Hei 7-281425 (paragraphs from [0014] to [0015]), a printing-out agent, a dye, a plasticizer for improving the flexibility and wear resistance of a coated film of the image recording layer, a development accelerator, and a surfactant for enhancing the coating properties.

The above-mentioned conventional PS plate of positive-working mode or negative-working mode may further comprise an intermediate layer which is interposed between the substrate and the photosensitive image recording layer. In this case, it is preferable to provide the intermediate layer comprising a polymer compound comprising an acid radical-containing constituent and an onium radical-containing constituent, as stated in JP KOKAI No. 2000-105462.

The conventional PS plate of negative-working mode comprising the above-mentioned photosensitive resin composition is imagewise exposed to the ultraviolet rays, and then the development is conducted using a developing solution. The developing solution for the photosensitive resin composition used in the conventional PS plate of negative-working mode is typically an aqueous solution comprising an alkaline chemical, an organic solvent, a surfactant, a water softener, a reducing agent, an organic carboxylic acid, an inorganic salt, an anti-foaming agent, and other kinds of additives known to those skilled in the art, as required. Most preferable examples of the developing solution are shown in JP KOKOKU Nos. Sho 56-42860, Sho 58-54341 and Hei 2-37579, and JP KOKAI Nos. Sho 63-200154 and Sho 64-44445.

### [PS plate of photopolymerizable type]

### (Photosensitive image recording layer)

The photosensitive image recording layer of the PS plate of photopolymerizable type comprises a photosensitive photopolymerizable composition (which will be hereinafter referred to as "a photopolymerizable composition"), which comprises as the indispensable components an addition-polymerizable compound having an ethylenically unsaturated bond, a photopolymerization initiator, and a polymeric binder agent. The above-mentioned photopolymerizable composition may further comprise a variety of compounds serving as, for example, a coloring agent, a plasticizer, and a thermal polymerization inhibitor, if necessary.

The ethylenically unsaturated bond-containing compound for use in the photopolymerizable composition initiates addition polymerization by the action of the photopolymerization initiator when the photopolymerizable composition is exposed to active light, and is hardened by cross-linking. The ethylenically unsaturated bond-containing compound can be selected freely from the group consisting of compounds having at least one, preferably two or more terminal ethylenically unsaturated bonds. The aforementioned compounds may be, for example, in any form such as a monomer, a prepolymer including a dimmer, trimer and oligomer, or a mixture and copolymer thereof. Examples of the aforementioned monomer include esters of unsaturated carboxylic acids such as acrylic acid, methacrylic acid, itaconic acid, crotonic acid, isocrotonic acid, and maleic acid with aliphatic polyhydric alcohol compounds, and amides of the unsaturated carboxylic acids with aliphatic polyvalent amine compounds. Urethane based addition-polymerizable compounds are also preferable.

Depending upon the wavelength of light emitting from the employed light source, the photopolymerization initiator may appropriately be chosen from a variety of photopolymerization initiators, or two or more polymerization initiators may be used in combination to prepare a combined initiator system. For example, the initiator system disclosed in JP KOKAI No. 2001-22079 (paragraphs from [0021] to [0023]) is preferable.

The polymeric binder agent for use in the photopolymerizable composition is an organic high-molecular weight compound that is soluble or swellable in an aqueous alkaline solution because not only the polymer has to work as a film-forming agent for the photopolymerizable composition, but also the obtained photosensitive layer is required to be soluble in an alkaline developing solution. Preferable examples of the polymeric binder agent are shown in JP KOKAI No. 2001-22079 (paragraphs from [0036] to [0063]).

Moreover, the photopolymerizable composition may further comprise additives, for example, a surfactant for enhancing the coating properties, as shown in JP KOKAI No. 2001-22079 (paragraphs from [0079] to [0088]).

Further, it is preferable that a protective layer such as an oxygen barrier layer be provided on the photosensitive image recording layer to prevent the effect of the polymerization by oxygen. The oxygen barrier layer may comprise a polymer such as polyvinyl alcohol or copolymers thereof. Furthermore, an intermediate layer or adhesive layer as shown in JP KOKAI No. 2001-228608 (paragraphs from [0124] to [0165]) may be preferably provided under the photosensitive image recording layer of a photopolymerizable type.

The above-mentioned photosensitive PS plate comprising the photopolymerizable composition is subjected to image exposure using ultraviolet rays such as high-pressure mercury vapor lamp, argon laser, and ultraviolet laser, and then the development is carried out using a developing solution. The developing solution suitable for this type of PS plate is typically an aqueous solution comprising an alkaline chemical, an organic solvent, a surfactant, a water softener, a reducing agent, an organic carboxylic acid, an inorganic salt, an anti-foaming agent, and other kinds of additives known to those skilled in the art, as required. Most preferable examples of the developing solution are shown in JP KOKOKU No. Sho 58-54341, and JP KOKAI Nos. Hei 8-248643, 2002-91015, and Hei 8-171214.

An image portion formed in the above-mentioned image recording layer comprising the photopolymerizable composition forms a net-work structure by the polymerization reaction, and therefore the image portion is not easily dissolved in a solvent. As a result, correction of the image portion is difficult. By using the correction fluid of the present invention, the above-mentioned image portion that becomes unnecessary can be deleted in a very short time.

### [Thermal PS plate of positive-working mode]

### (Heat-sensitive image recording layer)

The heatsensitive image recording layer of a thermal PS plate of positive-working mode comprises an alkali-soluble polymer and a light-to-heat converter material. The alkali-soluble polymer is a homopolymer prepared from a monomer containing an acidic group, a copolymer comprising the above-mentioned monomer, and a mixture thereof. In light of the solubility in the employed alkaline developing solution, the alkali-soluble polymer comprising an acidic group such as (1) phenolic hydroxyl group (-Ar-OH) or (2) sulfonamide group (-SO₂NH-R) is preferable. In particular, the phenolic hydroxyl group is preferably employed in the alkali-soluble polymer because of the advantage in image forming performance by the image exposure using infrared laser beams or the like. Therefore, novolak resins such as phenol - formaldehyde resin, m-cresol - formaldehyde resin, p-cresol - formaldehyde resin, (mixture of m-cresol and p-cresol) - formaldehyde resin, and (mixture of phenol and cresol (m-cresol and/or p-cresol)) - formaldehyde resin; and pyrogallolacetone resin are preferably used as the alkali-soluble polymer. Other polymers disclosed in JP KOKAI No. 2001-305722 (paragraphs from [0023] to [0042]) are preferably employed.

In the heatsensitive layer of the thermal PS plate of positive-working mode, a portion not exposed to light is in such a state that is not soluble in the alkaline developing solution due to the interaction between the above-mentioned alkali-soluble polymer and the light-to-heat converter material. At a portion exposed to light, the light-to-heat converter material works to convert the light energy into thermal energy to set free the above-mentioned interaction efficiently, so that the light-exposed portion becomes soluble in the alkaline developing solution. In consideration of the recording sensitivity, pigments and dyes having absorption within the infrared region with wavelengths of 700 to 1200 nm are preferably used as the light-to-heat converter material. Specific examples of the above-mentioned dyes include azo dyes, metal complex salt azo dyes, pyrazoloneazo dyes, naphthoquinone dyes, anthraquinone dyes, phthalocyanine dyes, carbonium dyes, quinoneimine dyes, methine dyes, cyanine dyes, squarylium dyes, pyrylium salts, and metal thiolate complexes such as nickel thiolate complex. Of those dyes, cyanine dyes are preferable, in particular, cyanine dyes represented by formula (I) in JP KOKAI No. 2001-305722 are preferably used.

The composition for use in the thermal PS plate of positive-working mode may further comprise the same sensitivity controlling agent, printing-out agent, dye, and surfactant for improving the coating properties as used in the above-mentioned conventional PS plate of positive-working mode. More specifically, the compounds shown in JP KOKAI No. 2001-305722 (paragraphs from [0053] to [0059]) are preferably employed.

The heatsensitive image recording layer of the thermal PS plate of positive-working mode may have a single layered structure or a two-layered structure as described, for example, in JP KOKAI No. Hei 11-218914.

In the thermal PS plate of positive-working mode, an undercoating layer may be preferably provided between the substrate and the heatsensitive image recording layer. A variety of organic compounds as shown in JP KOKAI No. 2001-305722 (paragraph [0068]) can be used for the undercoating layer.

The thermal PS plate of positive-working mode is prepared buy providing the above-mentioned heatsensitive layer on a substrate, the heatsensitive layer comprising the thermosensitive composition comprising the alkali-soluble polymer and the light-to-heat converter material. The PS plate thus prepared is imagewise exposed to infrared laser beams, and then subjected to development using an alkaline developing solution. Preferable examples of the alkaline developing solution are shown in JP KOKOKU No. Sho 57-7427, JP Patent No. 3,086,354, and JP KOKAI Nos. Hei 11-216962, 2001-51406, 2001-174981, and 2002-72501.

### [Thermal PS plate of negative-working mode]

### (Heat-sensitive image recording layer)

In the heatsensitive image recording layer of the thermal PS plate of negative-working mode, a portion exposed to infrared radiation is cured to form an image portion.

For example, a heatsensitive layer of polymerization type is suitable for the thermal PS plate of negative-working mode. Such a polymerizable layer comprises (A) an infrared absorption agent, (B) a radical generator (radical polymerization initiator), (C) a radical-polymerizable compound which causes a polymerization reaction by the action of a radical generated by the radical generator (B) to cure, and (D) a binder polymer.

In the polymerizable layer, infrared radiation absorbed by the infrared absorption agent is converted into thermal energy, which decomposes the radical polymerization initiator such as an onium salt to generate a radical. The radical thus generated induces a chain reaction of polymerization of the radical-polymerizable compound that is selected from the group consisting of compounds having a terminal ethylenically unsaturated bond, so that the portion exposed to infrared radiation becomes cured.

As the infrared absorption agent (A), for example, the previously mentioned light-to-heat converter material for use in the heatsensitive image recording layer of the thermal PS plate of positive-working mode can be used. In particular, cyanine dyes as mentioned in JP KOKAI No. 2001-133969 (paragraphs from [0017] to [0019]) can be preferably used. Onium salts can be used as the radical generator (B), and specific examples of the onium salts preferably used are shown in JP KOKAI No. 2001-133969 (paragraphs from [0030] to [0033]). The radical-polymerizable compound (C) can be selected from the group consisting of compounds having at least one, preferably two or more terminal ethylenically unsaturated bonds. With respect to the binder polymer (D), organic linear polymers are preferable, in particular, organic linear polymers that are soluble or swellable in water or a weak alkaline aqueous solution are preferably chosen. Especially, (meth)acrylic resins having benzyl group or allyl group and carboxyl group on the side chain thereof are suitable because such (meth)acrylic resins can offer an excellent balance of film-strength, sensitivity, and developing performance. Specific examples of the radical-polymerizable compound (C) and the binder polymer (D) are shown in JP KOKAI No. 2001-133969 (paragraphs from [0036] to [0060]) in detail. Other additives, for example, a surfactant for achieving better coating properties may be contained as shown in JP KOKAI No. 2001-133969 (paragraphs from [0061] to [0068]).

In addition to the above-mentioned polymerizable layer, a heatsensitive image recording layer of acid cross-linking type is preferably used for the thermal PS plate of negative-working mode. The image recording layer of acid cross-linking type comprises (E) a compound capable of generating an acid by the application of light or heat, which compound will be hereinafter referred to as "an acid generator", (F) a compound that causes cross-linking by the action of the acid generated, which compound will be hereinafter referred to as "a cross-linking agent", and (G) an alkali-soluble polymer that is reactive to the cross-linking agent (F) under the presence of the acid. In order to make the most efficient use of the energy of infrared laser, the acid cross-linking layer may further comprise the previously mentioned infrared absorption agent (A).

As the acid generator (E), there can be employed compounds that can be thermally decomposed to generate an acid, such as a photopolymerization initiator, a light color change agent such as a dyestuff, and an acid generator for use in a micro resist. Examples of the cross-linking agent (F) include (i) an aromatic compound having as a substituent a hydroxymethyl group or alkoxymethyl group, (ii) a compound having a N-hydroxymethyl group, N-alkoxymethyl group, or N-acyloxymethyl group, and (iii) an epoxy compound. As the alkali-soluble polymer (G), novolak resins and polymers having a hydroxyaryl group in the side chain thereof can be employed.

The aforementioned heatsensitive image recording layer of polymerization type or acid cross-linking type is provided on a substrate to obtain a thermal PS plate of negative-working mode. The PS plate thus obtained is imagewise exposed to infrared laser beams, and the development is conducted using an alkaline developing solution. Preferable examples of the developing solution are shown in JP KOKOKU No. Sho 57-7427, JP KOKAI No. 2001-133969 (paragraphs from [0119] to [0123]), JP Patent Application Nos. 2002-47985 and 2002-59297, and U.S. Patent No. 5,766,826.

The lithographic printing plates made from the above-mentioned thermal PS plate of positive-working mode and thermal polymerization type PS plate of negative-working mode have the disadvantage that an image portion formed in each image recording layer comprising the infrared absorption agent is relatively vulnerable to various chemicals. When the correction fluid of the present invention is used for those PS plates, image portions adjacent to an image portion that needs correction can be effectively prevented from being damaged.

### [Substrate]

As the substrate for PS plate on which each of the above-mentioned image recording layers is provided, an aluminum plate is usually employed. The aluminum plate herein used is a plate-shaped member made of pure aluminum or an aluminum alloy comprising aluminum as the main component and other elements in trace amounts. Examples of the elements for making the aluminum alloy include silicon, iron, manganese, copper, magnesium, chromium, zinc, bismuth, nickel, and titanium. Such elements may be contained in an amount of 10% by mass or less in the composition of the aluminum alloy. Although completely pure aluminum is most preferable, it is difficult to obtain such a completely pure aluminum plate in light of the refining technology. An aluminum plate containing minimum amounts of other elements is suitable for the substrate. The aluminum alloy containing other elements in the above-mentioned proportions is considered to be serviceable in the present invention. The composition of the aluminum plate is not particularly limited, and conventional aluminum materials can be appropriately used for the substrate. For example, aluminum materials of JIS A 1050, JIS A 1100, JIS A 1200, JIS A 3003, JIS A 3103 and JIS A 3005 are preferably used. The thickness of the aluminum plate may be in the range of about 0.1 mm to about 0.6 mm for the substrate of the PS plate.

The aluminum plate may be subjected to degreasing treatment when necessary, using, for example, a surfactant or an alkaline aqueous solution to remove rolling oil attached to the surface of the aluminum plate before the treatment for roughening the aluminum surface.

Thereafter, treatments for obtaining a surface roughness, anodizing, and making the aluminum surface hydrophilic are appropriately used in combination for obtaining the aluminum substrate. For example, the aluminum substrate may be prepared by following the method as mentioned in JP KOKAI No. 2001-356494.

On the aluminum substrate thus prepared, an image recording layer is provided by coating to obtain a PS plate. Before providing the image recording layer on the substrate, an intermediate layer may be provided thereon. A variety of organic polymers are preferably used for the intermediate layer, for example, as disclosed in JP KOKAI No. 2001-356494.

Furthermore, a backcoating layer comprising an organic polymer may be provided on the rear side of the substrate, opposite to the image recording layer side, if necessary, in order to avoid the image recording layer from taking scratches when one PS plate is laid upon another.

After the development process, the PS plate is subjected to posttreatments such as water-washing, rinsing, and desensitizing, which treatments may be appropriately employed in combination. Thus, a printing plate for lithographic printing can be obtained. In the case where an image portion formed in the printing plate needs correction, the image portion is deleted by applying the correction fluid of the present invention to the corresponding portion. For effective deletion of the image portion, it is recommended that the correction fluid be applied to the image portion of a printing plate that has been sufficiently washed with water after development, not a printing plate immediately after development. Or, the correction fluid may be applied to the printing plate which has been subjected to gumming up although the deleting rate is slightly decreased. To delete the image portion in the printing plate using the correction fluid of the present invention, the correction fluid is generally applied to the desired image portion with a brush. After application of the correction fluid, the image portion is allowed to stand for about 5 seconds to about one minute, and thereafter the correction fluid is removed from the printing plate by washing with water. Thus, the image portion coming in contact with the correction fluid is completely deleted to become a non-image portion. After such correction, the printing plate may be subjected to usual treatment such as gumming up, to be ready for printing.

The invention will now be illustrated in detail by reference to the following examples wherein, unless otherwise indicated, all parts and percentages are by weight.

### [Example 1]

A correction fluid of the present invention was prepared by following the procedure shown below.

### [Correction Fluid A]

The following components were mixed to prepare a liquid:

| | |
|---|---|
| Propylene carbonate | 8.3 parts |
| Ethylene carbonate | 33 parts |
| Dimethylacetamide | 27.6 parts |
| Solvent comprising tetramethylbenzene ("Swasol 1800" (trademark), available from Maruzen Petrochemical Co., Ltd.) | 8.4 parts |
| Pure water | 8 parts |

To the resultant liquid, 1.2 parts of hydroxypropyl cellulose (containing hydroxypropyl group in an amount of 70 to 95%) and 8.5 parts of a block copolymer of oxyethylene and oxypropylene (with a molecular weight of 10,000, having a content of ethylene oxide of 80%, prepared by subjecting ethylene oxide to polymerization at both ends of polypropylene glycol with an average molecular weight of 2,000) were added and dispersed. After that, 1.0 part of acetic acid, 0.5 parts of oxalic acid, and 0.003 parts of Crystal Violet were successively dissolved in the above-mentioned liquid with stirring, so that a uniform solution was obtained. In the solution thus obtained, 4.0 parts of silicon dioxide particles ("Aerosil 380" (trademark), made by Nippon Aerosil Co., Ltd., having a primary particle mean particle size of about 7 nm) were dispersed. Thus, a correction fluid A in a viscous liquid form was prepared. The pH of the correction fluid A was 6.0.

### [Examples 2 to 11 and Comparative Examples 1 to 6]

The procedure for preparation of the correction fluid A in Example 1 was repeated except that the formulation for the correction fluid A was changed as shown in Tables 1 to 3, so that correction fluids B to K and comparative correction fluids (a) to (f) were respectively prepared in Examples 2 to 11 and Comparative Examples 1 to 6.

Tables 1 to 3 show the formulation (unit: parts by weight) and the pH of each correction fluid.

**Table 1**

| Example | 1 | 2 | 3 | 4 | 5 | 6 |
|---|---|---|---|---|---|---|
| Correction fluid | A | B | C | D | E | F |
| Propylene carbonate | 8.3 | 9.3 | 10.7 | 9.3 | 9.3 | 9.0 |
| Ethylene carbonate | 33.0 | 34.0 | 42.7 | 34.0 | 34.0 | 36.0 |
| Dimethylacetamide | 27.6 | 28.6 | 26.6 | 28.6 | 28.6 | 23.0 |
| "Swasol 1800" ^{*1} | 8.4 | 8.4 | - | 8.4 | 8.4 | 8.2 |
| Fluorozirconic acid (40% aqueous solution) | - | 2.0 | 2.0 | - | - | 1.7 |
| Hydrosilicofluoric acid (40% aqueous solution) | - | - | - | 2.0 | - | - |
| Borofluoric acid (40% aqueous solution) | - | - | - | - | 2.0 | - |
| Fluorotitanic acid (40% aqueous solution) | - | - | - | - | - | - |
| Trifluoroacetic acid | - | - | - | - | - | - |
| Ammonium bifluoride (40% aqueous solution) | - | - | - | - | - | - |
| Pure water | 8.0 | 7.1 | 7.3 | 7.1 | 7.1 | 7.0 |
| Hydroxypropyl cellulose ^{*2} | 1.2 | - | - | - | - | 2.0 |
| Oxyethylene - oxypropylene block copolymer ^{*3} | 8.5 | 5.0 | 4.9 | 5.0 | 5.0 | 6.0 |
| Polyvinylpyrrolidone ^{*4} | - | 0.3 | - | 0.3 | 0.3 | - |
| Vinyl methyl ether - maleic anhydride copolymer (molar ratio of 1:1) ^{*5} | - | - | 1.5 | - | - | - |
| Fluorine-containing surfactant ^{*6} | - | - | 0.5 | - | - | - |
| Sodium alkylbenzenesulfonate | - | - | - | - | - | - |
| Phosphoric acid (85%) | - | - | 0.5 | - | - | - |
| Acetic acid | 1.0 | 1.0 | 0.5 | 1.0 | 1.0 | - |
| Oxalic acid | 0.5 | - | - | - | - | - |
| Triethanolamine | - | 1.0 | 1.0 | 1.0 | 1.0 | 0.7 |
| Crystal Violet | 0.003 | 0.003 | 0.003 | 0.003 | 0.003 | 0.003 |
| Silicon dioxide particles ^{*7} | 4.0 | 4.0 | 4.8 | 4.0 | 4.0 | 6.0 |
| p H | 6.0 | 4.5 | 4.0 | 4.5 | 5.0 | 4.5 |

| | | | | | | |
|---|---|---|---|---|---|---|
| ^{*1} A solvent comprising tetramethylbenzene, available from Maruzen Petrochemical Co., Ltd. | | | | | | |
| ^{*2} Hydroxypropyl cellulose containing hydroxypropyl group in an amount of 70 to 95%. | | | | | | |
| ^{*3} A block copolymer of oxyethylene and oxypropylene, having a molecular weight of 10,000 and a content of ethylene oxide of 80%, prepared by subjecting ethylene oxide to polymerization at both ends of polypropylene glycol with an average molecular weight of 2,000. | | | | | | |
| ^{*4} "K-15" made by G.A.F. | | | | | | |
| ^{*5} The intrinsic-viscosity number is in the range of 2.6 to 3.5 at 25°C when 1 g of the copolymer is dissolved in 100 g of methyl ethyl ketone. | | | | | | |
| ^{*6} "Megafac F-781-F" (trademark), made by Dainippon Ink & Chemicals, Incorporated | | | | | | |
| ^{*7} "Aerosil 380" (trademark), made by Nippon Aerosil Co., Ltd., having a primary particle mean particle size of about 7 nm. | | | | | | |

**Table 2**

| Example | 7 | 8 | 9 | 10 | 11 |
|---|---|---|---|---|---|
| Correction fluid | G | H | I | J | K |
| Propylene carbonate | 9.3 | 10.7 | 9.3 | 9.3 | 9.0 |
| Ethylene carbonate | 34.0 | 42.7 | 34.0 | 34.0 | 36.0 |
| Dimethylacetamide | 28.6 | 26.6 | 28.6 | 28.6 | 23.0 |
| "Swasol 1800" ^{*1} | 8.4 | - | 8.4 | 8.4 | 8.2 |
| Fluorozirconic acid (40% aqueous solution) | 1.5 | 1.5 | - | - | - |
| Hydrosilicofluoric acid (40% aqueous solution) | - | - | - | - | - |
| Borofluoric acid (40% aqueous solution) | - | - | - | - | - |
| Fluorotitanic acid (40% aqueous solution) | - | - | 1.5 | - | - |
| Trifluoroacetic acid | - | - | - | 1.5 | - |
| Ammonium bifluoride (40% aqueous solution) | - | - | - | - | 1.7 |
| Pure water | 7.1 | 7.3 | 7.1 | 7.1 | 7.0 |
| Hydroxypropyl cellulose ^{*2} | - | - | - | - | 2.0 |
| Oxyethylene - oxypropylene block copolymer ^{*3} | 5.0 | 4.9 | 5.0 | 5.0 | 6.0 |
| Polyvinylpyrrolidone ^{*4} | 0.3 | - | 0.3 | 0.3 | - |
| Vinyl methyl ether - maleic anhydride copolymer (molar ratio of 1:1)^{*5} | - | 1.5 | - | - | - |
| Fluorine-containing surfactant^{*6} - | - | 0.5 | - | - | - |
| Sodium alkylbenzenesulfonate | - | - | - | - | - |
| Phosphoric acid (85%) | 0.5 | - | - | 0.5 | - |
| Acetic acid | 0.5 | - | - | 0.5 | - |
| Oxalic acid | - | - | - | - | - |
| Triethanolamine | 2.7 | 1.5 | - | 3.0 | 0.7 |
| Crystal Violet | 0.003 | 0.003 | 0.003 | 0.003 | 0.003 |
| Silicon dioxide particles^{*7} | 4.0 | 4.8 | 4.0 | 4.0 | 6.0 |
| pH | 5.0 | 5.5 | 4.5 | 6.5 | 6.0 |

In Table 2, (^{*1}) to (^{*7}) show the same definition as in Table 1.

**Table 3**

| Comparative Example | 1 | 2 | 3 | 4 | 5 | 6 |
|---|---|---|---|---|---|---|
| Comparative correction fluid | (a) | (b) | (c) | (d) | (e) | (f) |
| Propylene carbonate | 13.8 | - | 9.3 | 9.3 | - | - |
| Ethylene carbonate | 55.1 | - | 34.0 | 34.0 | - | - |
| Dimethylacetamide | - | 80.0 | - | - | - | - |
| Dimethylformamide | - | - | 28.6 | - | - | - |
| N-methylpyrrolidone | - | - | - | 28.6 | 40.0 | 40.0 |
| N,N-dimethylformamide | - | - | - | - | 40.0 | - |
| Dioxolan | - | - | - | - | - | 40.0 |
| "Swasol 1800" ^{*1} | 8.4 | - | 8.4 | 8.4 | - | - |
| Fluorozirconic acid (40% aqueous solution) | - | 2.0 | - | - | - | 2.0 |
| Hydrosilicofluoric acid (40% aqueous solution) | - | - | - | 2.0 | - | - |
| Borofluoric acid (40% aqueous solution) | 2.0 | - | 2.0 | - | 2.0 | - |
| Fluorotitanic acid (40% aqueous solution) | - | - | - | - | - | - |
| Trifluoroacetic acid | - | - | - | - | - | - |
| Ammonium bifluoride (40% aqueous solution) | - | - | - | - | - | - |
| Pure water | 7.0 | 7.4 | 7.1 | 7.1 | 7.0 | 7.4 |
| Hydroxypropyl cellulose ^{*2} | 1.2 | - | - | - | 1.7 | - |
| Oxyethylene - oxypropylene block copolymer ^{*3} | 8.5 | 5.0 | 5.0 | 5.5 | 8.5 | 5.5 |
| Polyvinylpyrrolidone ^{*4} | - | 0.3 | 0.3 | 0.3 | - | 0.3 |
| Vinyl methyl ether - maleic anhydride copolymer (molar ratio of 1:1)^{*5} | - | - | - | - | - | - |
| Fluorine-containing surfactant ^{*6} | - | - | - | - | - | - |
| Sodium alkylbenzenesulfonate - | | 0.5 | 0.5 | 0.5 | - | 0.5 |
| Phosphoric acid (85%) | - | - | - | - | - | - |
| Acetic acid | 0.5 | 0.5 | - | - | - | - |
| Oxalic acid | - | - | 0.5 | - | - | - |
| Triethanolamine | - | - | - | - | - | - |
| Crystal Violet | 0.003 | 0.003 | 0.003 | 0.003 | 0.003 | 0.003 |
| Silicon dioxide particles ^{*7} | 4.0 | 4.8 | 4.5 | 4.5 | 4.0 | 4.8 |
| p H | 4.0 | 4.5 | 4.5 | 5.0 | 5.5 | 5.0 |

In Table 3, (^{*1}) to (^{*7}) show the same definition as in Table 1.

Each of the correction fluids prepared in Examples 1 to 11 and Comparative Examples 1 to 6 was evaluated in terms of generation of an odor and concern about the safety in the working environment. The results are shown in Table 4.

**Table 4**

| | Correction Fluid | Odor in Working Environment | Concern about Safety |
|---|---|---|---|
| Example 1 | A | Faint odor | Nil |
| Example 2 | B | Faint odor | Nil |
| Example 3 | C | Faint odor | Nil |
| Example 4 | D | Faint odor | Nil |
| Example 5 | E | Faint odor | Nil |
| Example 6 | F | Faint odor | Nil |
| Example 7 | G | Faint odor | Nil |
| Example 8 | H | Faint odor | Nil |
| Example 9 | I | Faint odor | Nil |
| Example 10 | J | Faint odor | Nil |
| Example 11 | K | Faint odor | Nil |
| Comparative Example 1 | (a) | Faint odor | Nil |
| Comparative Example 2 | (b) | Odor of volatile component | Nil |
| Comparative Example 3 | (c) | Odor of volatile component | Present |
| Comparative Example 4 | (d) | Faint odor | Present |
| Comparative Example 5 | (e) | Odor of volatile component | Present |
| Comparative Example 6 | (f) | Bad smell | Present |

### [Test 1]

Each of the correction fluids prepared in Examples 1 to 11 and Comparative Examples 1 to 6 was used to correct an image portion formed in a lithographic printing plate which was obtained from a conventional PS plate of positive-working mode. The printing plate was fabricated in such a manner as shown below.

### (Fabrication of Lithographic Printing Plate)

### <Preparation of substrate>

An aluminum plate with a thickness of 0.3 mm was polished with a brush and electrochemically treated to have a rough surface in a nitric acid solution. Then, the aluminum plate was thoroughly washed, and subjected to anodization in a sulfuric acid solution to form an anodized layer with a deposition amount of 2.5 g/m² on the surface of the aluminum plate. Thereafter, the aluminum plate was washed with water and dried.

A coating liquid for a photosensitive layer was prepared by dissolving 3 parts of an esterified product of resorcinbenzaldehyde resin with naphthoquinone-1,2-diazide-5-sulfonyl chloride, which was synthesized in such a manner as disclosed in Examples of JP KOKAI No. Sho 56-1044, 9 parts of cresol- formalin novolak resin, and 0.12 parts of Victoria Pure Blue BOH (made by Hodogaya Chemical Co., Ltd.) in 100 parts of 2-methoxyethanol. The coating liquid was coated on the above-mentioned aluminum plate using a rotary coater and dried, so that a photosensitive layer with a coating amount of 2.8 g/m² was provided on the aluminum plate. The conventional PS plate of positive-working mode was thus prepared.

A half tone positive transparency was brought into contact with the PS plate and exposed to a metal halide lamp located at a distance of 0.8 m from the PS plate for 60 seconds. Thereafter, development was carried out using a developing solution with the following formulation:

### [Developing solution]

| | |
|---|---|
| Potassium silicate A (SiO₂: 26%, K₂O: 13.5%) | 120 parts |
| 86% potassium hydroxide | 15.5 parts |
| Water | 500 parts |

The lithographic printing plate was thus obtained, but the edge portion of the positive transparency faintly remained on the printing plate as an image portion.

A brush was filled with each correction fluid and the correction fluid was applied to the image portion in the printing plate corresponding to the edge portion of the transparency. Then, the printing plate was allowed to stand for a given period of time within a range from 5 seconds to 10 minutes for evaluation. After a lapse of a given period of time, water was sprayed on the printing plate to remove the correction fluid therefrom.

It was observed whether the surrounding portions of the correction fluid-applied portion were adversely affected, in other words, whether the image portions around the correction fluid-applied portion became blurred on a printed material. It was determined how long the printing plate had to be left alone after the correction fluid was applied until the unnecessary image portion was deleted from the printing plate, and also until the portion from which the image had been deleted became unstained at the beginning of printing operation. Further, the degree to which the substrate was damaged after the image portion was kept in contact with the correction fluid for 10 minutes and thereafter washed with water to remove the correction fluid was determined by inspecting whether the portion from which the image had been deleted was stained with printing ink at the beginning of printing operation. In this case, an aqueous solution of gum arabic with a Baume degree of 14° was coated on the printing plate after completion of the correcting operation, and the printing plate was set in an offset press to make 10,000 prints.

The results of the above-mentioned evaluation are shown in Table 5.

When the correction fluid of the present invention was used for the correcting operation, the image portion was completely deleted, with the hydrophilic layer being entirely exposed and no ghost image remaining at the portion from which the image had been deleted, although the image-deleted portion produced a slightly more whitish color as compared with other non-image portions. Therefore, it was very easy to check the printing plate after the correcting operation, and the time required to check the printing plate was curtailed. In addition, when printing operation was carried out using the above-mentioned printing plate, clear prints were obtained without any stains at the portion corresponding to the image portion deleted from the printing plate using the correction fluid. Furthermore, spreading of the correction fluid of the present invention on the PS plate can be minimized, so that a fine image portion was deleted with ease. The correction fluid of the present invention was considered to be excellent from the physiological viewpoint because of a high level of safety and minimum discomfort to the operating environment.

To cause the correction fluids obtained in Examples 1 to 11 to deteriorate forcibly, the correction fluids were allowed to stand at 50°C and 80%RH for 7 days. After the storage, the deleting capability of the correction fluid was examined. The deleting performance of each correction fluid was equal to that of the correction fluid immediately after the preparation.

**Table 5**

| Correction Fluid | Effects on Surrounding Image Portions(Image Blur) | Time Required to Delete Image on PS Plate (sec) * | Time Required to Delete Image on Printed Material (sec)** | Ink Stain at image-deleted Portion *** |
|---|---|---|---|---|
| A | Nil | 10 | 10 | Nil |
| B | Nil | 10 | 10 | Nil |
| C | Nil | 10 | 10 | Nil |
| D | Nil | 15 | 15 | Nil |
| E | Nil | 15 | 15 | Nil |
| F | Nil | 10 | 10 | Nil |
| G | Nil | 10 | 10 | Nil |
| H | Nil | 10 | 10 | Nil |
| I | Nil | 10 | 10 | Slightly observed. |
| J | Nil | 10 | 15 | Slightly observed. |
| K | Nil | 10 | 15 | Slightly observed. |
| (a) | Nil | 20 | 20 | Nil |
| (b) | Nil | 5 | 5 | Nil |
| (c) | Significant | 10 | 10 | Nil |
| (d) | Significant | 10 | 10 | Nil |
| (e) | Significant | 10 | 40 | Observed. |
| (f) | Significant | 10 | 30 | Nil |

| | | | | |
|---|---|---|---|---|
| * The time when the correction fluid was kept in contact with the image portion after the application, which time was needed to delete the image portion from the printing plate. | | | | |
| ** The time when the correction fluid was kept in contact with the image portion after the application until it was made possible to recognize a portion in the printed material corresponding to the image-deleted portion in the printing plate as an ink-free portion at the beginning of printing operation. | | | | |
| ***The degree of ink stain due to the damage of the substrate after the image portion was kept in contact with the correction fluid for 10 minutes. | | | | |

### [Test 2]

Each of the correction fluids prepared in Examples 1 to 11 and Comparative Examples 1 to 6 was used to correct an image portion formed in a lithographic printing plate obtained from a thermal PS plate of positive-working mode comprising a substrate subjected to a silicate treatment and coated with an undercoating layer. The thermal PS plate was developed using a silicate developing solution.

### (Fabrication of Lithographic Printing Plate)

### <Preparation of substrate>

After an aluminum plate (JIS A 1050) having a thickness of 0.3 mm was washed with trichloroethylene for degreasing, the aluminum plate was surface-grained with a nylon brush and an aqueous suspension of 400-mesh pumice powder and then sufficiently washed with water. Thereafter, the aluminum plate was etched by immersing in a 25% aqueous solution of sodium hydroxide at 45°C for 9 seconds, followed by washing with water. Subsequently, the aluminum plate was immersed in a 20% nitric acid solution for 20 seconds, followed by washing with water. In this case, the amount of the aluminum plate subjected to etching to obtain a grained surface was about 3 g/m². The aluminum plate was then anodized in a 7% sulfuric acid solution at a current density of 15 A/dm². The result was that an anodized layer with a thickness of 3 g/m² was deposited on the aluminum plate. The aluminum plate was washed with water and dried.

The aluminum plate thus prepared was treated with an aqueous solution comprising 2.5% by weight of sodium silicate at 30°C for 10 seconds.

A coating liquid for undercoating layer was prepared by mixing the following components.

| (Formulation for coating liquid of undercoating layer) | |
|---|---|
| Copolymer of the following formula: | |
| (molecular weight: 28,000) | 0.3 parts |
| 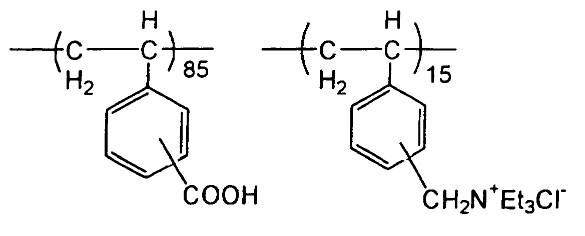 | |
| Methanol | 100 parts |
| Water | 1 part |

The coating liquid for undercoating layer was coated on the aluminum plate and dried at 80°C for 15 seconds so as to have a deposition amount of 15 mg/m² on a dry basis.

A substrate for the PS plate was thus prepared.

### <Formation of photosensitive image recording layer>

The following components were mixed to prepare a coating liquid for formation of a photosensitive image recording layer.

| (Formulation for coating liquid of photosensitive layer) | |
|---|---|
| m,p-cresol novolak | |
| (m/p ratio: 6/4, weight average molecular weight: 8,000, content of unreacted cresol: 0.5% by weight) | 1.0 part |
| Cyanine dye A of the following formula: | 0.1 parts |
| 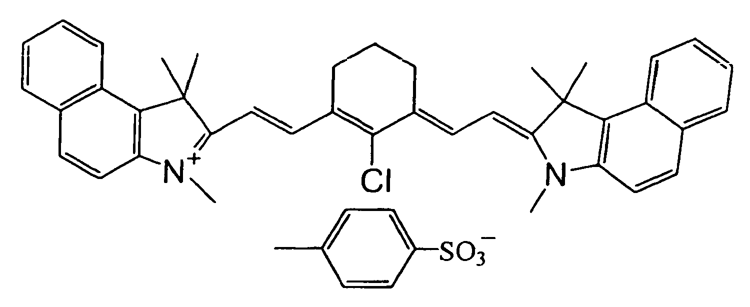 | |
| Tetrahydrophthalic anhydride | 0.05 parts |
| p-toluenesulfonic acid | 0.002 parts |
| Ethyl Violet having as a counter ion 6-hydroxy-β-naphthalenesulfonic acid | 0.02 parts |
| Fluorine-containing surfactant | |
| ("Megafac F-781-F" (trademark), made by Dainippon Ink & Chemicals, Incorporated) | 0.05 parts |
| Methyl ethyl ketone | 12.0 parts |

The coating liquid for the photosensitive layer was coated on the substrate and dried to have a deposition amount of 1.8 g/m² on a dry basis, whereby a photosensitive image recording layer was provided on the substrate. The PS plate was thus obtained.

Using a commercially available plate setter "Trendsetter 3244F" (trademark), made by Creo Products Inc., the above-mentioned PS plate was subjected to image exposure at a rotational frequency of 150 rpm, and development was carried out using an alkaline developing solution (with a pH of about 13) having the following formulation. Thus, the lithographic printing plate was obtained.

| (Formulation for alkaline developing solution) | |
|---|---|
| SiO₂·K₂O | |
| (molar ratio of K₂O/SiO₂= 1.1) | 4.0% |
| Citric acid | 0.5% |
| Polyethylene glycol (weight average molecular weight = 1000) | 0.5% |
| Water | 95.0% |

On the printing plate thus obtained, there remained unnecessary image portions caused by uneven irradiation with laser. Each of the correction fluids obtained in Examples 1 to 11 and Comparative Examples 1 to 6 was used for correction of the above-mentioned unnecessary image portions in the same manner as in the Test 1. To evaluate the performance of the correction fluids, prints were made using the above-mentioned printing plate. The results are shown in Table 6.

**Table 6**

| Correction Fluid | Effects on Surrounding Image Portions(Image Blur) | Time Required to Delete Image on PS Plate (sec) * | Time Required to Delete Image on Printed Material (sec)** | Ink Stain at Image-deleted Portion *** |
|---|---|---|---|---|
| A | Nil | 10 | 10 | Nil |
| B | Nil | 10 | 10 | Nil |
| C | Nil | 10 | 10 | Nil |
| D | Nil | 15 | 15 | Nil |
| E | Nil | 15 | 15 | Nil |
| F | Nil | 5 | 5 | Nil |
| G | Nil | 5 | 10 | Nil |
| H | Nil | 5 | 10 | Nil |
| I | Nil | 5 | 10 | Slightly observed. |
| J | Nil | 5 | 15 | Slightly observed. |
| K | Nil | 5 | 15 | Slightly observed. |
| (a) | Nil | 20 | 20 | Nil |
| (b) | Nil | 5 | 5 | A little observed. |
| (c) | Significant | 10 | 10 | Nil |
| (d) | Significant | 10 | 10 | Nil |
| (e) | Significant | 10 | 40 | Observed. |
| (f) | Significant | 15 | 40 | Nil |

| | | | | |
|---|---|---|---|---|
| * The time when the correction fluid was kept in contact with the image portion after the application, which time was needed to delete the image portion from the printing plate. | | | | |
| **The time when the correction fluid was kept in contact with the image portion after the application until it was made possible to recognize a portion in the printed material corresponding to the image-deleted portion in the printing plate as an ink-free portion at the beginning of printing operation. | | | | |
| *** The degree of ink stain due to the damage of the substrate after the image portion was kept in contact with the correction fluid for 10 minutes. | | | | |

### [Test 3]

Each of the correction fluids prepared in Examples 1 to 11 and Comparative Examples 1 to 6 was used to correct an image portion formed in a lithographic printing plate. The same thermal PS plate of positive-working mode as prepared in the Test 2 was set in the plate setter and subjected to image exposure and development in the same manner as in the Test 2 except that the silicate developing solution was replaced by a non-silicate developing solution. The lithographic printing plate was thus obtained.

The aforementioned non-silicate developing solution was prepared by adding 20 g of an amphoteric surfactant "PIONIN C-158G" (trademark), made by Takemoto Oil & Fat Co., Ltd., and 2.0 g of an antifoaming agent "OLFINE AK-02" (trademark), made by Nisshin Chemical Industry Co., Ltd. to one liter of a 45% aqueous solution of a potassium salt obtained by combining a nonreducing sugar and a base, that is, D-sorbitol and potassium oxide (K₂O) to provide a concentrate and diluting the concentrate with water nine times.

On the printing plate thus obtained, there remained unnecessary image portions caused by uneven irradiation with laser. Each of the correction fluids obtained in Examples 1 to 11 and Comparative Examples 1 to 6 was used for correction of the above-mentioned unnecessary image portions in the same manner as in the Test 1. To evaluate the performance of the correction fluids, prints were made using the above-mentioned printing plate. The results are shown in Table 7.

**Table 7**

| Correction Fluid | Effects on Surrounding Image Portions(Image Blur) | Time Required to Delete Image on PS Plate (sec) * | Time Required to Delete Image on Printed Material (sec)** | Ink Stain at Image-deleted Portion *** |
|---|---|---|---|---|
| A | Nil | 10 | 10 | Nil |
| B | Nil | 10 | 10 | Nil |
| C | Nil | 10 | 10 | Nil |
| D | Nil | 15 | 15 | Nil |
| E | Nil | 15 | 15 | Nil |
| F | Nil | 5 | 5 | Nil |
| G | Nil | 5 | 10 | Nil |
| H | Nil | 5 | 10 | Nil |
| I | Nil | 5 | 10 | Slightly observed. |
| J | Nil | 5 | 10 | Slightly observed. |
| K | Nil | 5 | 15 | Slightly observed. |
| (a) | Nil | 20 | 20 | Nil |
| (b) | Nil | 5 | 5 | Nil |
| (c) | Significant | 15 | 15 | Nil |
| (d) | Significant | 5 | 5 | A little observed. |
| (e) | Significant | 15 | 40 | Observed. |
| (f) | Significant | 15 | 30 | Nil |

| | | | | |
|---|---|---|---|---|
| *The time when the correction fluid was kept in contact with the image portion after the application, which time was needed to delete the image portion from the printing plate. | | | | |
| The time when the correction fluid was kept in contact with the image portion after the application until it was made possible to recognize a portion in the printed material corresponding to the image-deleted portion in the printing plate as an ink-free portion at the beginning of printing operation. | | | | |
| ***The degree of ink stain due to the damage of the substrate after the image portion was kept in contact with the correction fluid for 10 minutes. | | | | |

### [Test 4]

Each of the correction fluids prepared in Examples 1 to 11 and Comparative Examples 1 to 6 was used to correct an image portion formed in a lithographic printing plate obtained from a thermal PS plate of positive-working mode. The procedure for fabricating the thermal PS plate of positive-working mode as in the Test 2 was repeated except that the aluminum plate was not treated with sodium silicate after anodization and the undercoating layer was not provided on the aluminum plate. The PS plate thus obtained was set in the plate setter and subjected to image exposure and development in the same manner as in the Test 2 using the same silicate developing solution. The lithographic printing plate was thus obtained.

On the printing plate thus obtained, there remained unnecessary image portions caused by uneven irradiation with laser. Each of the correction fluids obtained in Examples 1 to 11 and Comparative Examples 1 to 6 was used for correction of the above-mentioned unnecessary image portions in the same manner as in the Test 1. To evaluate the performance of the correction fluids, prints were made using the above-mentioned printing plate. The results are shown in Table 8.

**Table 8**

| Correction Fluid | Effects on Surrounding Image Portions(Image Blur) | Time Required to Delete Image on PS Plate (sec) * | Time Required to Delete Image on Printed Material (sec)** | Ink Stain at Image-deleted Portion *** |
|---|---|---|---|---|
| A | Nil | 10 | 10 | Nil |
| B | Nil | 10 | 10 | Nil |
| C | Nil | 10 | 10 | Nil |
| D | Nil | 10 | 15 | Nil |
| E | Nil | 15 | 15 | Nil |
| F | Nil | 5 | 5 | Nil |
| G | Nil | 5 | 10 | Nil |
| H | Nil | 5 | 10 | Nil |
| I | Nil | 5 | 10 | Slightly observed. |
| J | Nil | 5 | 15 | Slightly observed. |
| K | Nil | 5 | 15 | Slightly observed. |
| (a) | Nil | 20 | 20 | Observed. |
| (b) | Nil | 5 | 5 | Observed. |
| (c) | Significant | 15 | 15 | A little observed. |
| (d) | Significant | 10 | 10 | A little observed. |
| (e) | Significant | 15 | 40 | Observed. |
| (f) | Significant | 15 | 30 | Observed. |

| | | | | |
|---|---|---|---|---|
| *The time when the correction fluid was kept in contact with the image portion after the application, which time was needed to delete the image portion from the printing plate. | | | | |
| The time when the correction fluid was kept in contact with the image portion after the application until it was made possible to recognize a portion in the printed material corresponding to the image-deleted portion in the printing plate as an ink-free portion at the beginning of printing operation. | | | | |
| ***The degree of ink stain due to the damage of the substrate after the image portion was kept in contact with the correction fluid for 10 minutes. | | | | |

### [Test 5]

Each of the correction fluids prepared in Examples 1 to 11 and Comparative Examples 1 to 6 was used to correct an image portion formed in a lithographic printing plate obtained from the same thermal PS plate of positive-working mode as in the Test 4 where the aluminum plate was not treated with sodium silicate after anodization and the undercoating layer was not provided on the aluminum plate. The PS plate thus obtained was set in the plate setter and subjected to image exposure and development in the same manner as in the Test 3 using the same non-silicate developing solution. The lithographic printing plate was thus obtained.

On the printing plate thus obtained, there remained unnecessary image portions caused by uneven irradiation with laser. Each of the correction fluids obtained in Examples 1 to 11 and Comparative Examples 1 to 6 was used for correction of the above-mentioned unnecessary image portions in the same manner as in the Test 1. To evaluate the performance of the correction fluids, prints were made using the above-mentioned printing plate. The results are shown in Table 9.

**Table 9**

| Correction Fluid | Effects on Surrounding Image Portions(Image Blur) | Time Required to Delete Image on PS Plate (sec) * | Time Required to Delete Image on Printed Material (sec)** | Ink Stain at Image-deleted Portion *** |
|---|---|---|---|---|
| A | Nil | 10 | 10 | Nil |
| B | Nil | 10 | 10 | Nil |
| C | Nil | 10 | 10 | Nil |
| D | Nil | 15 | 15 | Nil |
| E | Nil | 15 | 15 | Nil |
| F | Nil | 5 | 5 | Nil |
| G | Nil | 5 | 10 | Nil |
| H | Nil | 5 | 10 | Nil |
| I | Nil | 5 | 10 | Slightly observed. |
| J | Nil | 5 | 15 | Slightly observed. |
| K | Nil | 5 | 15 | Slightly observed. |
| (a) | Nil | 20 | 20 | Observed. |
| (b) | Nil | 5 | 5 | Observed. |
| (c) | Significant | 15 | 15 | A little observed. |
| (d) | Significant | 10 | 15 | A little observed. |
| (e) | Significant | 20 | 40 | Observed. |
| (f) | Significant | 20 | 30 | Observed. |

| | | | | |
|---|---|---|---|---|
| * The time when the correction fluid was kept in contact with the image portion after the application, which time was needed to delete the image portion from the printing plate. | | | | |
| **The time when the correction fluid was kept in contact with the image portion after the application until it was made possible to recognize a portion in the printed material corresponding to the image-deleted portion in the printing plate as an ink-free portion at the beginning of printing operation. | | | | |
| ***The degree of ink stain due to the damage of the substrate after the image portion was kept in contact with the correction fluid for 10 minutes. | | | | |

### [Test 6]

Each of the correction fluids prepared in Examples 1 to 11 and Comparative Examples 1 to 6 was used to correct an image portion formed in a lithographic printing plate which was obtained from a PS plate of photopolymerizable type. The printing plate was prepared by the method shown below.

### (Fabrication of Lithographic Printing Plate)

### <Preparation of substrate>

An aluminum plate (IS) having a thickness of 0.30 mm was surface-grained with a nylon brush (No. 8) and an aqueous suspension of 800-mesh pumice stone and then sufficiently washed with water. The aluminum plate was then etched by immersing in a 10% aqueous solution of sodium hydroxide at 70°C for 60 seconds, followed by successively washing with running water, a 20% nitric acid solution for neutralization, and water.

The surface of the aluminum plate was then electrolytically grained in a 1% aqueous solution of nitric acid by the application of an alternating current in the form of a sinusoidal wave at the applied voltage (V_{A}) of 12.7 V. The electrical quantity was set to 300 C/dm² at the anode side. At this stage, the surface roughness of the aluminum plate was measured and found to be 0.45 µm in terms of the center-line mean roughness (Ra) defined in JIS B 0601. Subsequently, the aluminum plate was immersed in a 30% aqueous solution of sulfuric acid at 55°C for 2 minutes to remove smut from the plate.

The aluminum plate was then anodized in a 20% aqueous solution of sulfuric acid at 33°C for 50 seconds at a current density of 5 A/dm², with a cathode being disposed opposite to the surface-grained surface of the aluminum plate. The result was that an anodized layer with a thickness of 2.7 g/m² was deposited on the aluminum plate. Thus, a substrate for the PS plate was prepared.

### <Formation of photosensitive image recording layer>

A photopolymerizable composition with the following formulation was coated on the above-mentioned substrate so that the coating amount was 1.5 g/m² on a dry basis and dried at 100°C for one minute, whereby a photosensitive image recording layer was provided on the substrate.

### <Photopolymerizable composition >

| | Parts by Weight |
|---|---|
| Ethylenically-unsaturated bond | |
| containing compound (A1) | 1.5 |
| Linear organic polymer (B1) | 2.0 |
| Sensitizer (C1) | 0.15 |
| Photopolymerization initiator (D1) | 0.2 |
| Dispersion of ε-phthalocyanine (F1) | 0.02 |
| Fluorine-containing surfactant | |
| ("Megafac F-177" (trademark), made by Dainippon Ink & Chemicals, Incorporated) | 0.03 |
| Methyl ethyl ketone | 9.0 |
| Propylene glycol monomethyl ether acetate | 7.5 |
| Toluene | 11.0 |

The above-mentioned ethylenically-unsaturated bond containing compound (A1), linear organic polymer (B1), sensitizer (C1), photopolymerization initiator (D1), and dispersion of ε-phthalocyanine (F1) are as follows:

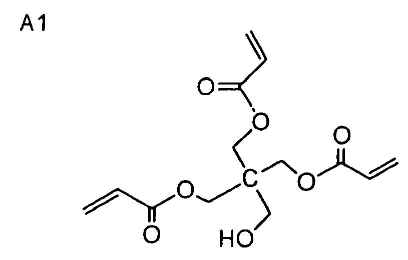

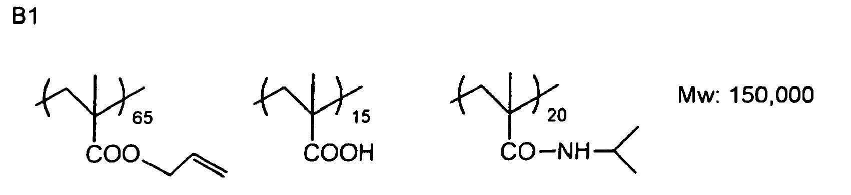

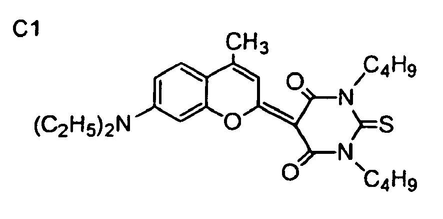

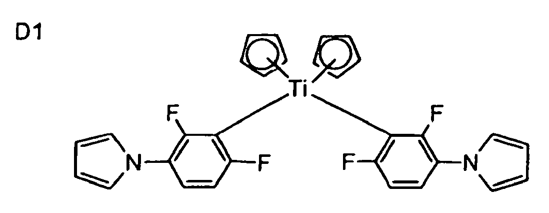

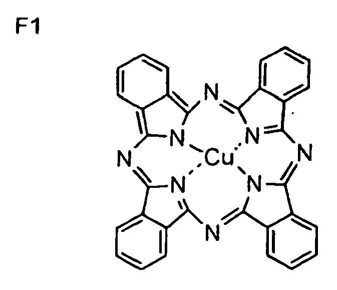

Subsequently, an aqueous solution containing 3% by weight of polyvinyl alcohol (with a degree of saponification of 98 mol% and a degree of polymerization of 500) was coated on the photosensitive image recording layer so as to have a coating amount of 2.5 g/m² on a dry basis and dried at 120°C for 3 minutes. The photopolymerizable type PS plate was thus obtained.

Solid images and dot images (with an increased dot percent from 1 to 99% by 1%) were subjected to scanning using FD . YAG laser ("PlateJet 4" (trademark), made by Cymbolic Sciences, Inc.) with an exposure of 100 µJ/cm² under the exposure conditions of 175 lines/inch at a density of 4000 dpi.

After completion of the light exposure, the PS plate was developed under the standard conditions using a commercially available automatic processor ("LP-850P2", made by Fuji Photo Film Co., Ltd.) equipped with a developing solution having the following formulation (pH: 11.5 at 25°C, electrical conductivity: 5 mS/cm) and a finishing gum ("FP-2W", made by Fuji Photo Film Co., Ltd.), whereby the lithographic printing plate was obtained. The PS plate was pre-heated so that the surface temperature of the plate reached 100°C, and the PS plate was immersed in the developing solution for about 15 seconds, with the temperature of the developing solution maintained at 30°C.

| (Formulation for developing solution) | |
|---|---|
| Potassium hydroxide | 0.15 g |
| Polyoxyethylene phenyl ether (n=13) | 5.0 g |
| Chelating agent "Chelest 400" (trademark) made by Chelest Co., Ltd. | 0.1 g |
| Water | 94.75 g |

On the printing plate thus obtained, there remained unnecessary image portions caused by uneven irradiation with laser. Each of the correction fluids obtained in Examples 1 to 11 and Comparative Examples 1 to 6 was used for correction of the above-mentioned unnecessary image portions in the same manner as in the Test 1. To evaluate the performance of the correction fluids, prints were made using the above-mentioned printing plate. The results are shown in Table 10.

**Table 10**

| Correction Fluid | Effects on Surrounding Image Portions(Image Blur) | Time Required to Delete Image on PS Plate (sec) * | Time Required to Delete Image on Printed Material (sec)** | Ink Stain at Image-deleted Portion *** |
|---|---|---|---|---|
| A | Nil | 20 | 20 | Nil |
| B | Nil | 20 | 20 | Nil |
| C | Nil | 20 | 20 | Nil |
| D | Nil | 30 | 30 | Nil |
| E | Nil | 30 | 30 | Nil |
| F | Nil | 20 | 20 | Nil |
| G | Nil | 20 | 20 | Nil |
| H | Nil | 20 | 20 | Nil |
| I | Nil | 20 | 30 | Nil |
| J | Nil | 30 | 30 | Nil |
| K | Nil | 30 | 30 | Nil |
| (a) | Nil | 40 | 40 | Observed. |
| (b) | Nil | 20 | 20 | Observed. |
| (c) | Significant | 40 | 60 | A little observed. |
| (d) | Significant | 60 | 60 | A little observed. |
| (e) | Significant | 60 | 90 | Observed. |
| (f) | Significant | 50 | 90 | Observed. |

| | | | | |
|---|---|---|---|---|
| *The time when the correction fluid was kept in contact with the image portion after the application, which time was needed to delete the image portion from the printing plate. | | | | |
| ** The time when the correction fluid was kept in contact with the image portion after the application until it was made possible to recognize a portion in the printed material corresponding to the image-deleted portion in the printing plate as an ink-free portion at the beginning of printing operation. | | | | |
| ***The degree of ink stain due to the damage of the substrate after the image portion was kept in contact with the correction fluid for 10 minutes. | | | | |

### [Test 7]

Each of the correction fluids prepared in Examples 1 to 11 and Comparative Examples 1 to 6 was used to correct an image portion formed in a lithographic printing plate which was obtained from a thermal PS plate of negative-working mode (thermal polymerization type). The printing plate was prepared by the method as shown below.

### (Fabrication of Lithographic Printing Plate)

### <Preparation of substrate>

A molten aluminum alloy (JIS A 1050) comprising 99.5% or more of aluminum, 0.30% of Fe, 0.10% of Si, 0.02% of Ti, and 0.013% of Cu was subjected to cleaning treatments such as degassing to remove unnecessary gases such as hydrogen from the molten metal and ceramic tube filter treatment. According to a die cast (DC) method, a solidified ingot in the form of a plate with a thickness of 500 mm was subjected to facing by 10 mm from the surface. The plate was then subjected to homogenized heat treatment at 550°C for 10 hours so as to prevent the intermetallic compound from becoming coarse. After hot rolling at 400°C, the plate was subjected to intermediate annealing at 500°C for 60 seconds in a continuous annealing furnace, followed by cold rolling, thereby obtaining an aluminum rolled plated with a thickness of 0.30 mm. By controlling the roughness of the reduction roll, the aluminum plate was adjusted to have a surface roughness of 0.2 µm in terms of the center-line mean roughness (Ra) defined in JIS B 0601 after cold rolling. Further, the aluminum plate was finished to have improved flatness using a tension leveler.

The above-mentioned aluminum plate was surface-treated so as to serve as a substrate of a PS plate for making the lithographic printing plate. First, degreasing was carried out in a 10% aqueous solution of sodium aluminate at 50°C for 30 seconds to remove the rolling oil from the surface of the aluminum plate. Then, the aluminum plate was subjected to neutralization and desmutting in a 30% aqueous solution of sulfuric acid at 50°C for 30 seconds.

Next, the aluminum plate was surface-grained to have an appropriate surface roughness for the purpose of improving the adhesion between the substrate and a photosensitive image recording layer and impart water-retaining properties to non-image portions. More specifically, the surface of the aluminum web was electrolytically grained in an aqueous solution comprising 1% of nitric acid and 0.5% of aluminum nitrate, which solution was maintained at 45°C, by the application of an electrical quantity of 240 C/dm² to the anode side in the alternating wave form with a duty ratio of 1:1 at a current density of 20 A/dm² using an indirect feeding cell. Subsequently, the aluminum web was subjected to etching in a 10% aqueous solution of sodium aluminate at 50°C for 30 seconds, and thereafter immersed in a 30% aqueous solution of sulfuric acid at 50°C for 30 seconds for neutralization and removal of smut from the web.

For improving the wear resistance, chemical resistance, and water-retaining properties, an anodized layer was formed on the aluminum web by anodization. Namely, the aluminum web was caused to pass through an electrolyte of a 20% aqueous solution of sulfuric acid at 35°C, with the application of a direct current at a current density of 14 A/dm² using an indirect feeding cell. The result was that an anodized layer with a thickness of 2.5 g/m² was electrolytically deposited on the aluminum web.

To ensure the water receptivity of non-image portions to be formed in the printing plate, the aluminum web was treated with silicate. The aluminum web was caused to pass through a 1.5% aqueous solution of No. 3 sodium silicate at 70°C so that the aluminum web was kept in contact with the silicate solution for 15 seconds, and thereafter washed with water. As a result, silicon (Si) was deposited on the aluminum web with a deposition amount of 10 mg/m². The aluminum web thus prepared showed a surface roughness of 0.25 µm in terms of the center-line mean roughness (Ra) defined in JIS B 0601. A substrate for the PS plate was thus obtained.

A coating liquid for forming an undercoating layer was coated on the above-mentioned aluminum substrate using a wire bar, and dried at 90°C for 30 seconds using a warm-air dryer. The deposition amount of the coating liquid for the undercoating layer was 10 mg/m² on a dry basis.

| (Formulation for coating liquid of undercoating layer) | |
|---|---|
| Copolymer of ethyl methacrylate and sodium 2-acrylamide-2-methyl-1-propanesulfonate (molar ratio: 75:15) | 0.1 g |
| 2-aminoethylphosphonic acid | 0.1 g |
| Methanol | 50 g |
| Deionized water | 50 g |

### <Formation of photosensitive image recording layer>

A coating liquid for forming a photosensitive image recording layer was coated on the above-mentioned undercoating layer using a wire bar, and dried at 115°C for 45 seconds using a warm-air dryer. The deposition amount of the coating liquid for the photosensitive image recording layer was in the range of 1.2 to 1.3 g/m² on a dry basis.

| (Formulation for coating liquid of photosensitive layer) | |
|---|---|
| Infrared absorption agent (IR-6) | 0.08 g |
| Onium salt (01-6) | 0.30 g |
| Dipentaerythritol hexaacrylate | 1.00 g |
| Copolymer of allyl methacrylate and methacrylic acid (molar ratio: 80:20, weight average molecular weight: 120,000) | 1.00 g |
| Naphthalenesulfonate salt of Victoria Pure Blue | 0.40 g |
| Fluorine-containing surfactant | |
| ("Megafac F-176" (trademark), made by Dainippon Ink & Chemicals, Incorporated) | 0.01 g |
| Methyl ethyl ketone | 9.0 g |
| Methanol | 10.0 g |
| 1-methoxy-2-propanol | 8.0 g |

The above-mentioned infrared absorption agent (IR-6) and onium salt (OI-6) are as follows:

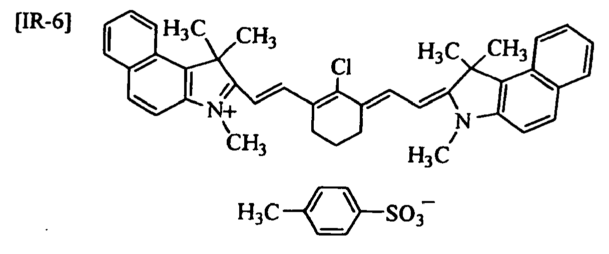

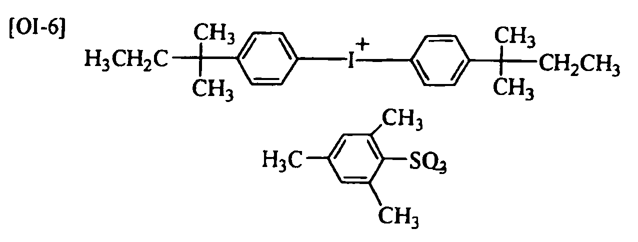

The thermal PS plate of negative-working mode (thermal polymerization type) was thus obtained.

Using a commercially available plate setter "Trendsetter 3244VFS" (trademark), made by Creo Products Inc., equipped with a 40W-infrared semiconductor laser of water-cooling type, the above-mentioned PS plate was subjected to image exposure under the conditions that the output power was 9 W, the external drum method was carried out at a rotational frequency of 210 rpm, and the energy applied to the plate was 100 mJ/cm², and the resolution was 2400 dpi.

After completion of the image exposure, development was carried out using an automatic PS processor "Stablon 900N" (trademark), made by Fuji Photo Film Co., Ltd. A diluent prepared by diluting a commercially available developer "DN-3C" made by Fuji Photo Film Co., Ltd. with water at a ratio of 1:1 was used for both the developing solution and the replenisher. The developer bath was maintained at 30°C. A diluent prepared by diluting "FN-6" made by Fuji Photo Film Co., Ltd. with water at a ratio of 1:1 was employed as the finisher.

On the printing plate thus obtained, there remained unnecessary image portions caused by uneven irradiation with laser. Each of the correction fluids obtained in Examples 1 to 11 and Comparative Examples 1 to 6 was used for correction of the above-mentioned unnecessary image portions in the same manner as in the Test 1. To evaluate the performance of the correction fluids, prints were made using the above-mentioned printing plate. The results are shown in Table 11.

**Table 11**

| Correction Fluid | Effects on Surrounding Image Portions(Image Blur) | Time Required to Delete Image on PS Plate (sec) * | Time Required to Delete Image on Printed Material (sec)** | Ink Stain at Image-deleted Portion *** |
|---|---|---|---|---|
| A | Nil | 10 | 10 | Nil |
| B | Nil | 10 | 10 | Nil |
| C | Nil | 10 | 10 | Nil |
| D | Nil | 20 | 20 | Nil |
| E | Nil | 20 | 20 | Nil |
| F | Nil | 10 | 10 | Nil |
| G | Nil | 10 | 10 | Nil |
| H | Nil | 10 | 10 | Nil |
| I | Nil | 10 | 15 | Nil |
| J | Nil | 10 | 20 | Nil |
| K | Nil | 10 | 20 | Nil |
| (a) | Nil | 20 | 20 | Observed. |
| (b) | Nil | 20 | 20 | Observed. |
| (c) | Significant | 30 | 60 | A little observed. |
| (d) | Significant | 40 | 60 | Observed. |
| (e) | Significant | 60 | 90 | A little observed. |
| (f) | Significant | 50 | 90 | Observed. |

| | | | | |
|---|---|---|---|---|
| * The time when the correction fluid was kept in contact with the image portion after the application, which time was needed to delete the image portion from the printing plate. | | | | |
| ** The time when the correction fluid was kept in contact with the image portion after the application until it was made possible to recognize a portion in the printed material corresponding to the image-deleted portion in the printing plate as an ink-free portion at the beginning of printing operation. | | | | |
| ***The degree of ink stain due to the damage of the substrate after the image portion was kept in contact with the correction fluid for 10 minutes. | | | | |

### Examples 12 to 17

The procedure for preparation of the correction fluid A in Example 1 was repeated except that the formulation for the correction fluid A was changed as shown in Table 12, so that correction fluids L to Q were respectively prepared in Examples 12 to 17.

Table 12 shows the formulation (unit: parts by weight) and the pH of each correction fluid.

**Table 12**

| Example | 12 | 13 | 14 | 15 | 16 | 17 |
|---|---|---|---|---|---|---|
| Correction fluid | L | M | N | O | P | Q |
| Propylene carbonate | 9.3 | 9.3 | 9.0 | 9.3 | 9.3 | 9.3 |
| Ethylene carbonate | 34.0 | 34.0 | 36.0 | 34.0 | 34.0 | 34.0 |
| Dimethylacetamide | 28.6 | 28.6 | 23.0 | 28.6 | 28.6 | 28.6 |
| "Swasol 1800" ^{*1} | 8.4 | 8.4 | 8.2 | 8.4 | 8.4 | 8.4 |
| Fluorozirconic acid (40% aqueous solution) | 0.08 | 1.5 | - | 1.5 | - | 0.5 |
| Hydrosilicofluoric acid (40% aqueous solution) | - | - | 1.7 | - | - | - |
| Borofluoric acid (40% aqueous solution) | - | - | - | - | - | - |
| Fluorotitanic acid (40% aqueous solution) | - | - | - | - | - | - |
| Trifluoroacetic acid | - | - | - | - | - | - |
| Ammonium bifluoride (40% aqueous solution) | - | - | - | - | - | - |
| Pure water | 7.1 | 7.1 | 7.0 | 7.1 | 7.1 | 7.1 |
| Hydroxypropyl cellulose ^{*2} | - | - | 2.0 | - | - | - |
| Oxyethylene - oxypropylene block copolymer ^{*3} | 5.0 | 5.0 | 6.0 | 5.0 | 5.0 | 5.0 |
| Polyvinylpyrrolidone^{*4} | 0.3 | 0.3 | - | 0.3 | 0.3 | 0.3 |
| Vinyl methyl ether - maleic anhydride copolymer (molar ratio of 1:1)^{*5} | - | - | - | - | - | - |
| Fluorine-containing surfactant ^{*6} | - | - | - | - | - | - |
| Sodium alkylbenzenesulfonate | - | - | - | - | - | - |
| Phosphoric acid (85%) | - | 0.5 | - | - | - | - |
| Acetic acid | - | 0.5 | - | - | - | - |
| Oxalic acid | - | - | - | - | - | - |
| Triethanolamine | - | 3.7 | 0.7 | - | - | 4.0 |
| Crystal Violet | 0.003 | 0.003 | 0.003 | 0.003 | 0.003 | 0.003 |
| Silicon dioxide particles ^{*7} | 4.0 | 4.0 | 6.0 | 4.0 | 4.0 | 4.0 |
| pH | 4.5 | 8.5 | 5.0 | 3.0 | 7.0 | 10.0 |

In Table 12, (^{*1}) to (^{*7}) show the same definition as in Table 1.

Each sample (100 g) of the correction fluids F to H obtained in Examples 6 to 8 and the correction fluids L to Q obtained in Examples 12 to 17 was placed in a 100-ml container made of rigid polyethylene to evaluate the preservation stability of each correction fluid by the method shown below.

### [Test 8]

The preservation stability of each correction fluid was evaluated using the lithographic printing plate made from the conventional PS plate of positive-working mode.

First, the lithographic printing plate was made by subjecting the PS plate to light exposure and development in the same manner as in the Test 1. The edge portion of the positive transparency faintly remained on the printing plate as an image portion.

A brush was filled with each correction fluid, and the correction fluid was applied to the above-mentioned image portion in the printing plate corresponding to the edge portion of the positive transparency. Then, the printing plate was allowed to stand for a given period of time within the range from 5 seconds to 10 minutes. After a lapse of a given period of time, water was sprayed on the printing plate to remove the correction fluid therefrom.

It was determined how long the printing plate had to be left alone after the correction fluid was applied until the unnecessary image portion was deleted from the printing plate. Also, it was determined how long the printing plate had to be left alone after the correction fluid was applied until the portion from which the image had been deleted became unstained at the beginning of printing operation. Further, the degree to which the substrate was damaged after the image portion was kept in contact with the correction fluid for 10 minutes and thereafter washed with water to remove the correction fluid was determined by inspecting whether the portion from which the image had been deleted was stained with printing ink at the beginning of printing operation. In this case, an aqueous solution of gum arabic with a Baume degree of 14° was coated on the printing plate after completion of the correcting operation, and the printing plate was set in an offset press to make 10,000 prints.

Under the assumption that the correction fluid is usually stored for an extended period of time, the above-mentioned test was carried out after each correction fluid was stored at 45°C for one month. In this case, the container was checked for the presence of deformation or breakage.

When the correction fluid of the present invention was used for the correcting operation, the image portion was completely deleted, with the hydrophilic layer being entirely exposed and no ghost image remaining at the portion from which the image had been deleted, although the image-deleted portion produced a slightly more whitish color as compared with other non-image portions. Therefore, it was very easy to check the printing plate obtained after the correcting operation, and the time required to check the printing plate was curtailed. In addition, when the printing plate thus prepared was subjected to printing operation, clear prints were obtained without any ink stains at the portion in the printed material corresponding to the portion in the printing plate from which the image had been deleted by the correction fluid of the present invention. The evaluation results were also satisfactory even after the storage at 45°C for one month, without any deformation or breakage of the container.

The results are shown in Table 13.

**Table 13**

| Correction Fluid (pH) | Time Required to Delete Image on PS Plate (sec) * | Time Required to Delete Image on Printed Material (sec) ** | Ink Stain at Image-deleted Portion *** | After Storage at 45°C for One Month | | | |
|---|---|---|---|---|---|---|---|
| | | | | Time Required to Delete Image on PS Plate (see) * | Time Required to Delete Image on Printed Material (sec)** | Ink Stain at Image-deleted Portion *** | Deformation or Breakage of Container |
| F (4.5) | 10 | 10 | Nil | 10 | 10 | Nil | Nil |
| G (5.0) | 10 | 10 | Nil | 10 | 10 | Nil | Nil |
| H (5.5) | 10 | 10 | Nil | 10 | 10 | Nil | Nil |
| L (4.5) | 10 | 15 | Nil | 10 | 15 | Nil | Nil |
| M(8.5) | 10 | 10 | Nil | 10 | 15 | Nil | Slight deformation |
| N (5.0) | 10 | 15 | Slightly observed. | 10 | 15 | Slightly observed. | Nil |
| O (3.0) | 10 | 10 | Nil | 40 | 60 | Nil | Slight deformation |
| P (7.0) | 10 | 40 | Nil | 10 | 40 | Nil | Nil |
| Q (10.0) | 10 | 10 | Slightly observed, | 40 | 60 | Slightly observed | Slight deformation |

| | | | | | | | |
|---|---|---|---|---|---|---|---|
| *The time when the correction fluid was kept in contact with the image portion after the application, which time was needed to delete the image portion from the printing plate. | | | | | | | |
| **The time when the correction fluid was kept in contact with the image portion after the application until it was made possible to recognize a portion in the printed material corresponding to the image-deleted portion in the printing plate as an ink-free portion at the beginning of printing operation. | | | | | | | |
| *** The degree of ink stain due to the damage of the substrate after the image portion was kept in contact with the correction fluid for 10 minutes. | | | | | | | |

### [Test 9]

The preservation stability of each correction fluid was evaluated using a lithographic printing plate made from a thermal PS plate of positive-working mode.

Each of the correction fluids F to H and L to Q prepared in Examples 6 to 8 and Examples 12 to 17 was used to correct an image portion formed in the lithographic printing plate. The image portion was formed by developing the thermal PS plate, which comprises a substrate not subjected to a silicate treatment and not coated with an undercoating layer, using a silicate developing solution.

### (Fabrication of Lithographic Printing Plate)

### <Preparation of substrate>

After an aluminum plate (JIS A 1050) having a thickness of 0.3 mm was washed with trichloroethylene for degreasing, the aluminum plate was surface-grained with a nylon brush and an aqueous suspension of 400-mesh pumice powder and then sufficiently washed with water. Thereafter, the aluminum plate was etched by immersing in a 25% aqueous solution of sodium hydroxide at 45°C for 9 seconds, followed by washing with water. Subsequently, the aluminum plate was immersed in a 20% nitric acid solution for 20 seconds, followed by washing with water. In this case, the amount of the aluminum plate subjected to etching to obtain a grained surface was about 3 g/m². The aluminum plate was then anodized in a 7% sulfuric acid solution at a current density of 15 A/dm². The result was that an anodized layer with a thickness of 3 g/m² was deposited on the aluminum plate. The aluminum plate was washed with water and dried.

### <Formation of photosensitive image recording layer>

The following components were mixed to prepare a coating liquid for formation of a photosensitive image recording layer.

| (Formulation for coating liquid of photosensitive layer) | |
|---|---|
| m,p-cresol novolak | |
| (m/p ratio: 6/4, weight average molecular weight: 8000, content of unreacted cresol: 0.5% by weight) | 1.0 part |
| Cyanine dye A of the following formula: | 0.1 parts |
| 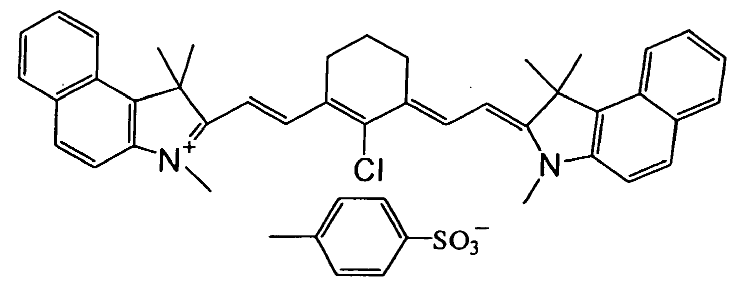 | |
| Tetrahydrophthalic anhydride | 0.05 parts |
| p-toluenesulfonic acid | 0.002 parts |
| Ethyl Violet having as a counter ion | |
| 6-hydroxy-β-naphthalenesulfonic acid | 0.02 parts |
| Fluorine-containing surfactant | |
| ("Megafac F-781-F" (trademark), made by Dainippon Ink & Chemicals, Incorporated) | 0.05 parts |
| Methyl ethyl ketone | 12.0 parts |

The coating liquid for the photosensitive layer was coated on the substrate and dried to have a deposition amount of 1.8 g/m² on a dry basis, whereby a photosensitive image recording layer was provided on the substrate. The PS plate was thus obtained.

Using a commercially available plate setter "Trendsetter 3244F" (trademark), made by Creo Products Inc., the above-mentioned PS plate was subjected to image exposure at a rotational frequency of 150 rpm, and development was carried out using an alkaline developing solution (with a pH of about 13) having the following formulation. Thus, the lithographic printing plate was obtained.

| (Formulation for alkaline developing solution) | |
|---|---|
| SiO₂·K₂O | |
| (molar ratio of K₂O/SiO₂ = 1.1) | 4.0% |
| Citric acid | 0.5% |
| Polyethylene glycol (weight average molecular weight = 1000) | 0.5% |
| Water | 95.0% |

On the printing plate thus obtained, there remained unnecessary image portions caused by uneven irradiation with laser. Each of the correction fluids F to H and L to Q was used for correction of the above-mentioned unnecessary image portions, and the performance of each correction fluid was evaluated in the same manner as in the Test 8. The results are shown in Table 14.

**Table 14**

| Correction Fluid (pH) | Time Required to Delete Image on PS Plate (sec) * | Time Required to Delete Image on Printed Material (sec)** | Ink Stain at Image-deleted Portion*** | After Storage at 45°C for One Month | | | |
|---|---|---|---|---|---|---|---|
| | | | | Time Required to Delete Image on PS Plate (sec) * | Time Required to Delete Image on Printed Material (sec)** | Ink Stain at Image-deleted Portion *** | Deformation or Breakage of Container |
| F (4.5) | 5 | 5 | Nil | 5 | 5 | Nil | Nil |
| G (5.0) | 5 | 10 | Nil | 5 | 10 | Nil | Nil |
| H (5.5) | 5 | 10 | Nil | 5 | 10 | Nil | Nil |
| L (4.5) | 10 | 15 | Nil | 10 | 15 | Nil | Nil |
| M (8.5) | 10 | 10 | Nil | 10 | 15 | Nil | Slight deformation |
| N (5.0) | 10 | 15 | Slightly observed. | 10 | 15 | Slightly observed. | Nil |
| O (3.0) | 10 | 10 | Nil | 30 | 60 | Nil | Slight deformation |
| P (7.0) | 10 | 40 | Nil | 10 | 40 | Nil | Nil |
| Q (10.0) | 10 | 10 | Slightly observed. | 30 | 60 | Slightly observed. | Slight deformation |

| | | | | | | | |
|---|---|---|---|---|---|---|---|
| The time when the correction fluid was kept in contact with the image portion after the application, which time was needed to delete the image portion from the printing plate. | | | | | | | |
| "The time when the correction fluid was kept in contact with the image portion after the application until it was made possible to recognize a portion in the printed material corresponding to the image-deleted portion in the printing plate as an ink-free portion at the beginning of printing operation. | | | | | | | |
| *** The degree of ink stain due to the damage of the substrate after the image portion was kept in contact with the correction fluid for 10 minutes. | | | | | | | |

### [Test 10]

The preservation stability of each correction fluid was evaluated using a lithographic printing plate made from a thermal PS plate of positive-working mode.

Each of the correction fluids F to H and L to Q prepared in Examples 6 to 8 and Examples 12 to 17 was used to correct an image portion formed in the lithographic printing plate. The image portion was formed by developing the thermal PS plate, which comprises a substrate subjected to a silicate treatment and coated with an undercoating layer, using a non-silicate developing solution.

### (Fabrication of Lithographic Printing Plate)

### <Preparation of substrate>

After an aluminum plate (JIS A 1050) having a thickness of 0.3 mm was washed with trichloroethylene for degreasing, the aluminum plate was surface-grained with a nylon brush and an aqueous suspension of 400-mesh pumice powder and then sufficiently washed with water. Thereafter, the aluminum plate was etched by immersing in a 25% aqueous solution of sodium hydroxide at 45°C for 9 seconds, followed by washing with water. Subsequently, the aluminum plate was immersed in a 20% nitric acid solution for 20 seconds, followed by washing with water. In this case, the amount of the aluminum plate subjected to etching to obtain a grained surface was about 3 g/m². The aluminum plate was then anodized in a 7% sulfuric acid solution at a current density of 15 A/dm². The result was that an anodized layer with a thickness of 3 g/m² was deposited on the aluminum plate. The aluminum plate was washed with water and dried.

The aluminum plate thus prepared was treated with an aqueous solution comprising 2.5% by weight of sodium silicate at 30°C for 10 seconds.

A coating liquid for undercoating layer was prepared by mixing the following components.

| (Formulation for coating liquid of undercoating layer) | |
|---|---|
| Copolymer of the following formula: (molecular weight: 28,000) | 0.3 parts |
| 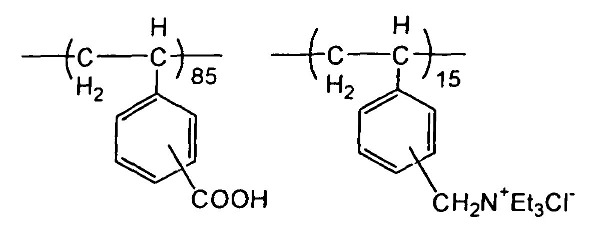 | |
| Methanol | 100 parts |
| Water | 1 part |

The coating liquid for undercoating layer thus prepared was coated on the aluminum plate and dried at 80°C for 15 seconds so as to have a deposition amount of 15 mg/m² on a dry basis.

A substrate for the PS plate was thus prepared.

### <Formation of photosensitive image recording layer>

The following components were mixed to prepare a coating liquid for formation of a photosensitive image recording layer.

| (Formulation for coating liquid of photosensitive layer) | |
|---|---|
| m,p-cresol novolak | |
| (m/p ratio: 6/4, weight average molecular weight: 8000, content of unreacted cresol: 0.5% by weight) | 1.0 part |
| Cyanine dye A of the following formula: | 0.1 parts |
| 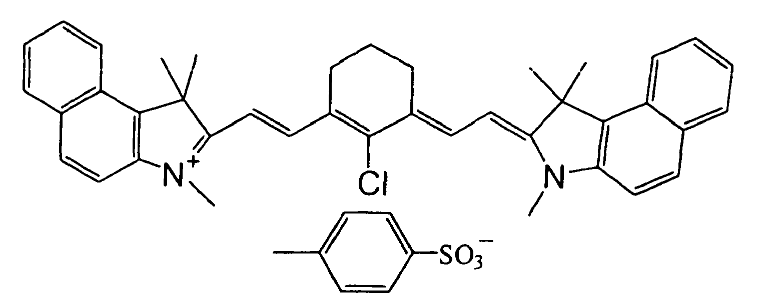 | |
| Tetrahydrophthalic anhydride | 0.05 parts |
| p-toluenesulfonic acid | 0.002 parts |
| Ethyl Violet having as a counter ion 6-hydroxy-β-naphthalenesulfonic acid | 0.02 parts |
| Fluorine-containing surfactant | |
| ("Megafac F-781-F" (trademark), made by Dainippon Ink & Chemicals, Incorporated) | 0.05 parts |
| Methyl ethyl ketone | 12.0 parts |

The coating liquid for the photosensitive layer was coated on the substrate and dried to have a deposition amount of 1.8 g/m² on a dry basis, whereby a photosensitive image recording layer was provided on the substrate. The PS plate was thus obtained.

The thermal PS plate of positive-working mode thus prepared was set in the plate setter and subjected to image exposure and development in the same manner as in the Test 9 except that the silicate developing solution was replaced by a non-silicate developing solution.

The aforementioned non-silicate developing solution was prepared by adding 20 g of an amphoteric surfactant "PIONIN C-158G" (trademark), made by Takemoto Oil & Fat Co., Ltd., and 2.0 g of an antifoaming agent "OLFINE AK-02" (trademark), made by Nisshin Chemical Industry Co., Ltd. to one liter of a 45% aqueous solution of a potassium salt prepared by combining a nonreducing sugar and a base, that is, D-sorbitol and potassium oxide (K₂O) to prepare a concentrate and diluting the concentrate with water nine times.

On the printing plate thus obtained, there remained unnecessary image portions caused by uneven irradiation with laser. Each of the correction fluids F to H and L to Q was used for correction of the above-mentioned unnecessary image portions, and the performance of each correction fluid was evaluated in the same manner as in the Test 8. The results are shown in Table 15.

**Table 15**

| Correction Fluid (pH) | Time Required to Delete Image on PS Plate (sec) * | Time Required to Delete Image on Printed Material (sec)** | Ink Stain at Image-deleted Portion*** | After Storage at 45°C for One Month | | | |
|---|---|---|---|---|---|---|---|
| | | | | Time Required to Delete Image on PS Plate (see)* | Time Required to Delete Image on Printed Material (sec)** | Ink Stain at Image-deleted Portion*** | Deformation or Breakage of Container |
| F (4.5) | 5 | 5 | Nil | 5 | 10 | Nil | Nil |
| G (5.0) | 5 | 10 | Nil | 5 | 10 | Nil | Nil |
| H (5.5) | 5 | 10 | Nil | 5 | 10 | Nil | Nil |
| L (4.5) | 5 | 15 | Nil | 5 | 15 | Nil | Nil |
| M (8.5) | 5 | 10 | Nil | 5 | 15 | Nil | Slight deformation |
| N (5.0) | 5 | 15 | Slightly observed. | 5 | 15 | Slightly observed. | Nil |
| O (3.0) | 5 | 10 | Nil | 30 | 50 | Nil | Slight deformation |
| P (7.0) | 5 | 40 | Nil | 5 | 40 | Nil | Nil |
| Q (10.0) | 5 | 10 | Slightly observed. | 30 | 50 | Slightly observed. | Slight deformation |

| | | | | | | | |
|---|---|---|---|---|---|---|---|
| *The time when the correction fluid was kept in contact with the image portion after the application, which time was needed to delete the image portion from the printing plate. | | | | | | | |
| **The time when the correction fluid was kept in contact with the image portion after the application until it was made possible to recognize a portion in the printed material corresponding to the image-deleted portion in the printing plate as an ink-free portion at the beginning of printing operation. | | | | | | | |
| *** The degree of ink stain due to the damage of the substrate after the image portion was kept in contact with the correction fluid for 10 minutes. | | | | | | | |

The correction fluids according to the present invention can delete the image portions formed in the PS plate in a very short time. The result is that the time required for the deleting process can be reduced, thereby improving the working efficiency in making the printing plates. The correction fluids of the present invention can delete the image portion that needs correction without adversely affecting other image portions adjacent to the target image portion. Owing to such an advantage of the correction fluids of the present invention, even a fine portion in elaborate images can be easily and perfectly eliminated from the printing plate.

Further, the correction fluids of the present invention contain no solvents that are harmful to the operators' health, and generate no offensive odor.

It is also confirmed that the time when the correction fluid is kept in contact with the image after the application, needed to delete the unnecessary image portion from the printing plate is substantially the same as the time when the correction fluid is kept in contact with the image after the application, needed to prevent a portion of the printed material corresponding to the image-deleted portion of the printing plate from being stained with printing ink at the beginning of printing operation. This can save the operator from having to inspect for the presence of the unnecessary image portion again and delete such an image portion, if any, in the course of printing operation. In other words, once the unnecessary image portion is found to be deleted from the printing plate, the corresponding portion will certainly be protected from being stained with printing ink soon after the initiation of the printing operation.

In addition to the above, such an effect of deleting the image portion can last with stability for an extended period of time. The correction fluid in the container can be prevented from leaking therefrom because the container does not cause any problem about the deformation and breakage during the storage. This effect becomes more noticeable when the correction fluid is adjusted within the particular pH range.

## Claims

1. A correction fluid for lithographic printing plate, comprising a carbonic acid ester, and at least one compound selected from group (A) consisting of dimethylacetamide and diethylacetamide.

2. The correction fluid of claim 1, which further comprises at least one compound selected from compounds of group (B) consisting of fluorocarboxylic acids, hydrogen fluoride alkaline compounds, fluoroalkaline compounds, and hydrofluoric acids of a metal belonging to Group 4 of Periodic Table

3. The correction fluid of claim 1 or 2, wherein the carbonic acid ester comprises at least one compound selected from the group consisting of compounds represented by formulas (2) and (3): 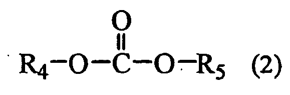 wherein R₄ and R₅ may be the same or different, and each represent an alkyl group which may have a substituent, a cycloalkyl group which may have a substituent, an alkenyl group which may have a substituent, or an aryl group which may have a substituent; 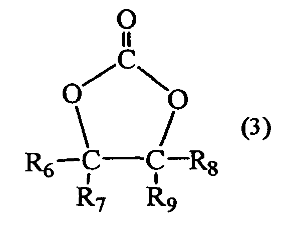 wherein R₆ to R₉ may be the same or different, and each represent hydrogen atom, an alkyl group which may have a substituent, a cycloalkyl group which may have a substituent, an alkenyl group which may have a substituent, or an aryl group which may have a substituent, and R₆ and R₇, R₈ and R₉, or R₇ and R₉ may form a ring in combination.

4. The correction fluid of any of claims 1 to 3, wherein the carbonic acid ester is contained in an amount of 20 to 80% by weight based on the total weight of the correction fluid

5. The correction fluid of any of claims 1 to 4, wherein the carbonic acid ester comprises at least one selected from the group consisting of dimethyl carbonate, ethyl methyl carbonate, diethyl carbonate, diphenyl carbonate, ethylene carbonate, and propylene carbonate.

6. The correction fluid of any of claims 1 to 5, wherein the carbonic acid ester comprises ethylene carbonate and propylene carbonate.

7. The correction fluid of any of claims 1 to 6, wherein the carbonic acid ester comprises ethylene carbonate and propylene carbonate at a ratio by weight of (90:10) to (10:90).

8. The correction fluid of any of claims 1 to 7, wherein the carbonic acid ester comprises ethylene carbonate and propylene carbonate at a ratio bay weight of (90:10) to (50:50).

9. The correction fluid of any of claims 1 to 8, wherein the compound selected from the group (A) is contained in an amount of 5 to 50% by weight based on the total weight of the correction fluid.

10. The correction fluid of any of claims 1 to 9, wherein the ratio by weight of the carbonic acid ester to the compound selected from the group (A) is in a range of (90:10) to (10:90).

11. The correction fluid of any of claims 1 to 10, wherein the total amount of the carbonic acid ester and the compound selected from the group (A) is in a range of 40 to 90% by weight based on the total weight of the correction fluid.

12. The correction fluid of any of claims 2 to 11, wherein the compound of group (B) is selected from the group consisting of fluorofatty acids; fluorodicarboxylic acids; compounds represented by formula of MF-HF, wherein M is an alkali metal or N(R²¹) (R²²)(R²³) (R²⁴), in which R²¹, R²², R²³ and R²⁴ may be the same or different and each represent hydrogen atom or a hydrocarbon group having 1 to 6 carbon atoms; compounds represented by formula of M'F, wherein M' is an alkali metal or N(R³¹) (R³²)(R³³) (R³⁴), in which R³¹, R³², R³³ and R³⁴ may be the same or different and each represent hydrogen atom or a hydrocarbon group having 1 to 6 carbon atoms; and compounds represented by M"H₂F₆, wherein M" is a metal element belonging to Group 4 of Periodic Table.

13. The correction fluid of any of claims 2 to 12, wherein the compound of group (B) is selected from the group consisting of trifluoroacetic acid, tetrafluorosuccinic acid, lithium bifluoride, potassium bifluoride, sodium bifluoride, ammonium bifluoride, lithium fluoride, potassium fluoride, sodium fluoride, ammonium fluoride, fluorozirconic acid, and fluorotitanic acid.

14. The correction fluid of any of claims 2 to 13, wherein the compound of group (B) is contained in an amount of 0.01 to 20.0% by weight based on the total weight of the correction fluid.

15. The correction fluid of any of claims 1 to 14, further comprising at least one compound selected from the group consisting of acid compounds and base compounds.

16. The correction fluid of any of claims 1 to 15, having a pH range of 1.0 to 9.0.

17. The correction fluid of claim 16, having a pH range of 4.0 to 9.0.

18. The correction fluid of claim 17, having a pH range of 4.0 to 7.0.

## Patentansprüche

1. Korrekturflüssigkeit für eine lithographische Druckplatte, umfassend einen Kohlensäureester und mindestens eine Verbindung, ausgewählt aus den Verbindungen der Gruppe (A), bestehend aus Dimethylacetamid und Diethylacetamid.

2. Korrekturflüssigkeit nach Anspruch 1, weiterhin umfassend mindestens eine Verbindung, ausgewählt aus den Verbindungen der Gruppe (B), bestehend aus Fluorcarbonsäuren, alkalischen Fluorwasserstoffverbindungen, alkalischen Fluorverbindungen und Fluorwasserstoffsäuren eines Metalls der Gruppe 4 des Periodensystems der Elemente.

3. Korrekturflüssigkeit nach Anspruch 1 oder 2, wobei der Kohlensäureester mindestens eine Verbindung umfasst, ausgewählt aus der Gruppe, bestehend aus den Verbindungen der Formeln (2) und (3): 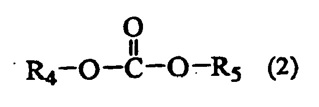 worin R₄ und R₅, die gleich oder verschieden sein können, jeweils eine Alkylgruppe, die substituiert sein kann, eine Cycloalkylgruppe, die substituiert sein kann, eine Alkenylgruppe, die substituiert sein kann, oder eine Arylgruppe, die substituiert sein kann, bedeuten; 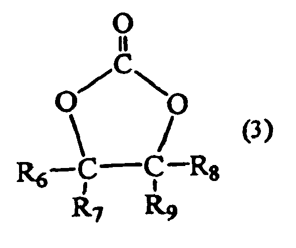 worin R₆ bis R₉, die gleich oder verschieden sein können, jeweils ein Wasserstoffatom, eine Alkylgruppe, die substituiert sein kann, eine Cycloalkylgruppe, die substituiert sein kann, eine Alkenylgruppe, die substituiert sein kann, oder eine Arylgruppe, die substituiert sein kann, bedeuten, und R₆ und R₇, R₈ und R₉, oder R₇ und R₉ können zusammen einen Ring bilden.

4. Korrekturflüssigkeit nach einem der Ansprüche 1 bis 3, wobei der Kohlensäureester in einer Menge im Bereich von 20 bis 80 Gew.% enthalten ist, bezogen auf das Gesamtgewicht der Korrekturflüssigkeit.

5. Korrekturflüssigkeit nach einem der Ansprüche 1 bis 4, wobei der Kohlensäureester mindestens eine Verbindung umfasst, ausgewählt aus der Gruppe, bestehend aus Dimethylcarbonat, Ethylmethylcarbonat, Diethylcarbonat, Diphenylcarbonat, Ethylencarbonat und Propylencarbonat.

6. Korrekturflüssigkeit nach einem der Ansprüche 1 bis 5, wobei der Kohlensäureester Ethylencarbonat und Propylencarbonat umfasst.

7. Korrekturflüssigkeit nach einem der Ansprüche 1 bis 6, wobei der Kohlensäureester Ethylencarbonat und Propylencarbonat in einem Gewichtsverhältnis im Bereich von (90:10) bis (10:90) umfasst.

8. Korrekturflüssigkeit nach einem der Ansprüche 1 bis 7, wobei der Kohlensäureester Ethylencarbonat und Propylencarbonat in einem Gewichtsverhältnis im Bereich von (90:10) bis (50:50) umfasst.

9. Korrekturflüssigkeit nach einem der Ansprüche 1 bis 8, wobei die Verbindung, ausgewählt aus den Verbindungen der Gruppe (A), in einer Menge im Bereich von 5 bis 50 Gew.% enthalten ist, bezogen auf das Gesamtgewicht der Korrekturflüssigkeit.

10. Korrekturflüssigkeit nach einem der Ansprüche 1 bis 9, wobei das Gewichtsverhältnis von Kohlensäureester zu der Verbindung, ausgewählt aus den Verbindungen der Gruppe (A), im Bereich von (90:10) bis (10:90) liegt.

11. Korrekturflüssigkeit nach einem der Ansprüche 1 bis 10, wobei die Gesamtmenge des Kohlensäureesters und der Verbindung, ausgewählt aus den Verbindungen der Gruppe (A), im Bereich von 40 bis 90 Gew.% liegt, bezogen auf das Gesamtgewicht der Korrekturflüssigkeit.

12. Korrekturflüssigkeit nach einem der Ansprüche 2 bis 11, wobei die Verbindung, die aus den Verbindungen der Gruppe (B) ausgewählt ist, ausgewählt ist aus der Gruppe, bestehend aus Fluorfettsäuren; Fluordicarbonsäuren; Verbindungen der Formel MF·HF, worin M ein Alkalimetall oder die Gruppe N(R²¹)(R²²)(R²³)(R²⁴) ist, worin R²¹, R²², R²³ und R²⁴, die gleich oder verschieden sein können, jeweils ein Wasserstoffatom oder eine Kohlenwasserstoffgruppe mit 1 bis 6 Kohlenstoffatomen bedeuten; Verbindungen der Formel M'F, worin M' ein Alkalimetall oder die Gruppe N(R³¹)(R³²)(R³³)(R³⁴) ist, worin R³¹, R³², R³³ und R³⁴, die gleich oder verschieden sein können, jeweils ein Wasserstoffatom oder eine Kohlenwasserstoffgruppe mit 1 bis 6 Kohlenstoffatomen bedeuten; und Verbindungen der Formel M"H₂F₆, worin M" ein metallisches Element der Gruppe 4 des Periodensystems der Elemente ist.

13. Korrekturflüssigkeit nach einem der Ansprüche 2 bis 12, wobei die Verbindung, die aus den Verbindungen der Gruppe (B) ausgewählt ist, ausgewählt ist aus der Gruppe, bestehend aus Trifluoressigsäure, Tetrafluorbernsteinsäure, Lithiumbifluorid, Kaliumbifluorid, Natriumbifluorid, Ammoniumbifluorid, Lithiumfluorid, Kaliumfluorid, Natriumfluorid, Ammoniumfluorid, Fluorzirkonsäure und Fluortitansäure.

14. Korrekturflüssigkeit nach einem der Ansprüche 2 bis 13, wobei die Verbindung, die aus den Verbindungen der Gruppe (B) ausgewählt ist, in einer Menge im Bereich von 0,01 bis 20,0 Gew.% enthalten ist, bezogen auf das Gesamtgewicht der Korrekturflüssigkeit.

15. Korrekturflüssigkeit nach einem der Ansprüche 1 bis 14, weiterhin umfassend mindestens eine Verbindung, ausgewählt aus der Gruppe, bestehend aus sauren Verbindungen und basischen Verbindungen.

16. Korrekturflüssigkeit nach einem der Ansprüche 1 bis 15 mit einem pH-Wert im Bereich von 1,0 bis 9,0.

17. Korrekturflüssigkeit nach Anspruch 16 mit einem pH-Wert im Bereich von 4,0 bis 9,0.

18. Korrekturflüssigkeit nach Anspruch 17 mit einem pH-Wert im Bereich von 4,0 bis 7,0.

## Revendications

1. Fluide de correction pour plaque d'impression lithographique, comprenant un ester d'acide carbonique et au moins un composé choisi dans le groupe (A) consistant en le diméthylacétamide et le diéthylacétamide.

2. Fluide de correction selon la revendication 1 qui comprend en outre au moins un composé choisi parmi les composés du groupe (B) consistant en les acides fluorocarboxyliques, les composés alcalins de fluorure d'hydrogène, les composés fluoroalcalins et les acides fluorhydriques d'un métal appartenant au groupe 4 du tableau périodique.

3. Fluide de correction selon la revendication 1 ou 2, où l'ester d'acide carbonique comprend au moins un composé choisi dans le groupe consistant en les composés représentés par les formules (2) et (3) : 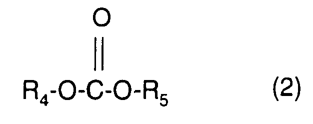 où R₄ et R₅ peuvent être identiques ou différents, et représentent chacun un groupe alkyle qui peut avoir un substituant, un groupe cycloalkyle qui peut avoir un substituant, un groupe alcényle qui peut avoir un substituant ou un groupe aryle qui peut avoir un substituant ; 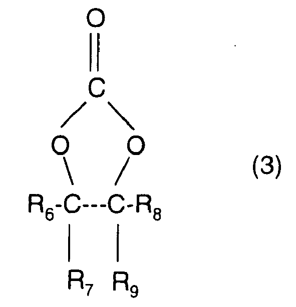 où R₆ à R₉ peuvent être identiques ou différents et représentent chacun un atome d'hydrogène, un groupe alkyle qui peut avoir un substituant, un groupe cycloalkyle qui peut avoir un substituant, un groupe alcényle qui peut avoir un substituant ou un groupe aryle qui peut avoir un substituant, et R₆ et R₇, R₈ et R₉ ou R₇ et R₉ peuvent former un cycle en combinaison.

4. Fluide de correction selon l'une quelconque des revendications 1 à 3, où l'ester d'acide carbonique est contenu en une quantité de 20 à 80 % en masse sur la base de la masse totale du fluide de correction.

5. Fluide de correction selon l'une quelconque des revendications 1 à 4, où l'ester d'acide carbonique comprend au moins un ester choisi dans le groupe consistant en le carbonate de diméthyle, le carbonate d'éthyle et de méthyle, le carbonate de diéthyle, !e carbonate de diphényle, le carbonate d'éthylène et le carbonate de propylène.

6. Fluide de correction selon l'une quelconque des revendications 1 à 5, où l'ester d'acide carbonique comprend du carbonate d'éthylène et du carbonate de propylène.

7. Fluide de correction selon l'une quelconque des revendications 1 à 6, où l'ester d'acide carbonique comprend du carbonate d'éthylène et du carbonate de propylène à un rapport en masse de (90:10) à (10:90).

8. Fluide de correction selon l'une quelconque des revendications 1 à 7, où l'ester d'acide carbonique comprend du carbonate d'éthylène et du carbonate de propylène à un rapport en masse de (90:10) à (50:50).

9. Fluide de correction selon l'une quelconque des revendications 1 à 8, où le composé choisi dans le groupe (A) est contenu en une quantité de 5 à 50 % en masse sur la base de la masse totale du fluide de correction.

10. Fluide de correction selon l'une quelconque des revendications 1 à 9, où le rapport en masse de l'ester d'acide carbonique au composé choisi dans le groupe (A) est dans un domaine de (90:10) à (10:90).

11. Fluide de correction selon l'une quelconque des revendications 1 à 10, où la quantité totale d'ester d'acide carbonique et de composé choisi dans le groupe (A) est dans un domaine de 40 à 90 % en masse sur la base de la masse totale du fluide de correction.

12. Fluide de correction selon l'une quelconque des revendications 2 à 11, où le composé du groupe (B) est choisi dans le groupe consistant en les acides gras fluorés; les acides fluorodicarboxyliques; les composés représentés par la formule MF.HF, où M est un métal alcalin ou N(R²¹)(R²²)(R²³)(R²⁴), où R²¹, R²², R²³ et R²⁴ peuvent être identiques ou différents et représentent chacun un atome d'hydrogène ou un groupe hydrocarboné ayant 1 à 6 atomes de carbone ; les composés représentés par la formule M'F, où M' est un métal alcalin ou N(R³¹)(R³²)(R³³)(R³⁴), où R³¹, R³², R³³ et R³⁴ peuvent être identiques ou différents et représentent chacun un atome d'hydrogène ou un groupe hydrocarboné ayant 1 à 6 atomes de carbone ; et les composés représentés par M"H₂F₆, où M" est un élément métallique appartenant au groupe 4 du tableau périodique.

13. Fluide de correction selon l'une quelconque des revendications 2 à 12, où le composé du groupe (B) est choisi dans le groupe consistant en l'acide trifluoroacétique, l'acide tétrafluorosuccinique, le bifluorure de lithium, le bifluorure de potassium, le bifluorure de sodium, le bifluorure d'ammonium, le fluorure de lithium, le fluorure de potassium, le fluorure de sodium, le fluorure d'ammonium, l'acide fluorozirconique et l'acide fluorotitanique.

14. Fluide de correction selon l'une quelconque des revendications 2 à 13, où le composé du groupe (B) est contenu en une quantité de 0,01 à 20,0 % en masse sur la base de la masse totale du fluide de correction.

15. Fluide de correction selon l'une quelconque des revendications 1 à 14, comprenant en outre au moins un composé choisi dans le groupe consistant en les composés acides et les composés basiques.

16. Fluide de correction selon l'une quelconque des revendications 1 à 15, ayant un domaine de pH de 1,0 à 9,0.

17. Fluide de correction selon la revendication 16, ayant un domaine de pH de 4,0 à 9,0.

18. Fluide de correction selon la revendication 17, ayant un domaine de pH de 4,0 à 7,0.
